# FASCICULE DE BREVET EUROPEEN

(11) **EP 3 216 056 B1**
(45) Date de publication et mention de la délivrance du brevet: **15.10.2025**
(21) Numéro de dépôt: 15791564.6
(22) Date de dépôt: 03.11.2015
(51) Int. Cl.: H01L 25/07, H01L 23/36, H01L 23/367, H01L 23/373, H01L 23/498, H01L 21/60, H01L 23/488, H01L 23/00

(54) **DISPOSITIF ELECTRONIQUE DE PUISSANCE A CELLULE DE COMMUTATION 3D VERTICALE**
ELEKTRONISCHE LEISTUNGSVORRICHTUNG MIT VERTIKALER 3D-SCHALTZELLE
ELECTRONIC POWER DEVICE WITH VERTICAL 3D SWITCHING CELL

(30) Priorité: 04.11.2014 FR 1460636
(43) Date de publication de la demande: 13.09.2017
(73) Titulaire: Commissariat à l'Energie Atomique et aux Energies Alternatives, 75015 Paris (FR); CENTRE NATIONAL DE LA RECHERCHE SCIENTIFIQUE, 75794 Paris Cedex 16 (FR)
(72) Inventeur: LETOWSKI, Bastien, F-38000 Grenoble (FR); CREBIER, Jean-Christophe, F-38690 Bevenais (FR); ROUGER,Nicolas, F-38100 Grenoble (FR); WIDIEZ, Julie, F-38000 Grenoble (FR)
(74) Mandataire: Brevalex
(86) Numéro de dépôt international: PCT/EP2015/075642
(87) Numéro de publication internationale: WO 2016/071366

(56) Documents cités:
- EP-A1- 2 511 952
- EP-A2- 2 731 132
- US-A1- 2005 012 117
- US-A1- 2007 096 278
- US-A1- 2011 266 683
- US-A1- 2014 264 919

## Description

### DOMAINE TECHNIQUE ET ART ANTÉRIEUR

L'invention concerne le domaine de l'électronique de puissance, et plus particulièrement un dispositif électronique de puissance comportant au moins une cellule de commutation réalisée en trois dimensions (3D) et intégrée verticalement sur un support, ainsi qu'un procédé de réalisation d'un tel dispositif électronique de puissance. L'invention concerne également un convertisseur statique comportant au moins un tel dispositif électronique de puissance, ainsi qu'un procédé de réalisation d'un tel convertisseur statique.

Le domaine de l'électronique de puissance suit le même chemin que celui de la microélectronique, avec un besoin croissant de réduction de l'encombrement et d'amélioration des performances des dispositifs. Des applications avec de plus en plus de fonctions intégrées sont développées, particulièrement pour les systèmes embarqués, du véhicule électrique à l'avion plus électrique, et doivent répondre à des critères de fiabilité et de reproductibilité mais également avoir un rapport coût/performance qui soit le meilleur possible.

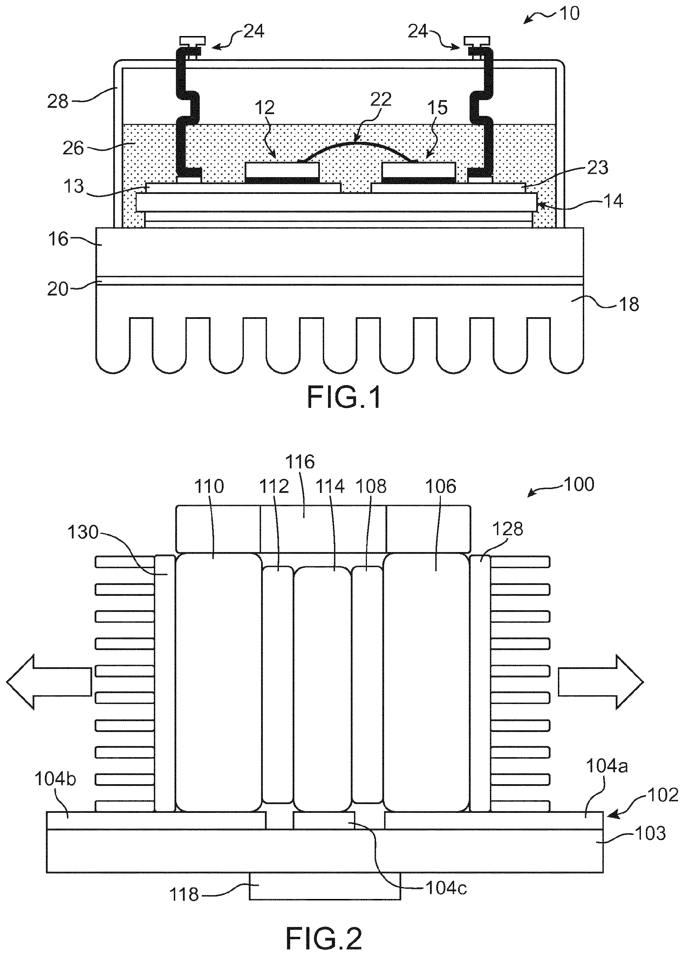

L'encapsulation des composants électroniques de puissance (notamment des diodes et transistors) est généralement réalisée par une mise en œuvre planaire (ou 2D) par report de puces sur support, de manière non collective. Un dispositif électronique de puissance 10 de type 2D est représenté sur la figure 1. Ce dispositif 10 comporte par exemple une ou plusieurs cellules de commutation. Sur l'exemple de la figure 1, une première puce 12, correspondant à un premier composant électronique de puissance, est fixée sur une première métallisation 13 d'un substrat métallisé 14, par exemple de type DBC (ou « Direct Bond Copper », c'est-à-dire comportant une céramique métallisée), via une brasure formant une liaison électrothermique entre la première puce 12 et la première métallisation 13. Une deuxième puce 15, correspondant à un deuxième composant électronique de puissance, est fixée sur une deuxième métallisation 23 du substrat 14. Les puces 12 et 15 forment ici une cellule de commutation du dispositif 10. Le substrat 14 est solidarisé à une face avant d'une semelle conductrice 16, par exemple en cuivre, également par une brasure. Une face arrière de la semelle 16 est solidarisée à un dissipateur thermique 18 par l'intermédiaire d'une graisse thermique 20. Une ou plusieurs liaisons électriques sont réalisées en face avant par des fils de bonding 22 (sur la figure 1, un fil 22 relie la première puce 12 à la deuxième puce 15), ou des rubans, et par des lyres de puissance 24 pour l'interconnexion avec l'extérieur du dispositif 10 (sur la figure 1, deux lyres de puissance 24 sont réalisées sur les métallisations 13 et 23). Les puces 12 et 15, le fil 22, une partie des lyres de puissance 24 et le substrat 14 sont entourés d'un gel passivant 26 et sont encapsulés dans un boîtier plastique 28 reposant sur la semelle 16. Les puces 12 et 15 sont également couplées à un ou plusieurs circuits de commande, également appelés drivers, non représentés sur la figure 1, qui permettent notamment de piloter les composants commandables, et donc de piloter la commutation de la ou des cellules de commutation du dispositif 10.

Une telle mise en œuvre planaire est une approche très mature qui atteint des niveaux de fiabilité élevés mais qui sont en butés. Par ailleurs, ce type de structure planaire et d'approche 2D avec extraction de la chaleur en face arrière et interconnexions électriques en face avant du dispositif introduit des interconnexions supplémentaires distantes du plan de masse formé par la semelle du dispositif. Les lyres de puissance et les fils de bonding introduisent des éléments parasites entre les composants électroniques de puissance et les capacités de découplage, ainsi qu'entre le ou les circuits de commande et la ou les électrodes de commande du ou des transistors de la ou des cellules de commutation.

Par ailleurs, un dispositif électronique de puissance réalisé selon cette approche 2D a également pour inconvénient d'avoir une capacité d'extraction de la chaleur qui est limitée. En effet, l'épanouissement du flux de chaleur sous les puces est limité par la largeur et l'épaisseur des pistes en cuivre du substrat DBC qui a également pour fonction d'isoler les contacts de puissance vis-à-vis de la partie refroidisseur du dispositif. L'agencement planaire du dispositif électronique de puissance avec toutes les interconnexions électriques disposées dans un même plan impose une mise en place de l'isolant électrique (céramique du substrat DBC) au plus près des composants de puissance, ce qui limite la conductivité thermique de l'ensemble réalisé.

Enfin, le substrat DBC introduit des capacités parasites entre les interconnexions de puissance et la masse du système qui forment des chemins de propagation parasite de mode commun très pénalisants pour la réalisation d'un convertisseur statique. En effet, ces chemins de propagation des perturbations électromagnétiques induisent des courants de mode commun dont l'amplitude des harmoniques dans le domaine fréquentiel est encadrée par des normes. Les dispositifs électroniques de puissance planaires peuvent produire des quantités importantes de perturbations de mode commun de part la structure même de leur package, ce qui impose de les utiliser en limitant leurs performances afin de limiter les perturbations engendrées.

Pour limiter ces inconvénients, plusieurs contraintes doivent être prises en compte lors de la conception des dispositifs électroniques de puissance 2D :
- optimiser les géométries des circuits afin d'avoir des symétries assurant un équilibrage des composants parasites et une réduction des courants de mode commun ;
- privilégier l'utilisation de lames de cuivre, telles que des Bus-Barre, à la place des fils de bonding, pour les potentiels d'alimentation DC+ et DC- du dispositif ;
- insérer des condensateurs de découplage à l'intérieur même des dispositifs, c'est-à-dire au plus près de la commutation, afin d'améliorer aussi la qualité de la commutation et réduire les courants de mode différentiel.

Les limitations des dispositifs planaires obligent le concepteur à trouver un compromis entre les contraintes thermiques, qui incitent à éloigner les puces les unes des autres, et les contraintes CEM (compatibilité électromagnétique) qui au contraire incitent à les rapprocher pour diminuer le rayonnement électromagnétique produit. Rapprocher les composants les uns des autres augmente toutefois les couplages perturbateurs entre les composants de puissance et les circuits annexes tels que les éléments de commande. De plus, rapprocher les composants les uns des autres peut, en raison de leurs températures de fonctionnement élevées, réduire leur fiabilité.

Un dispositif électronique de puissance ayant une structure 2D ou planaire présente donc les limitations suivantes :
- limitations thermiques : évacuation de la chaleur produite par le dispositif en fonctionnement par une seule face du dispositif ;
- limitations électriques : caractère inductif de la maille de commutation (fils de bonding et lyres de puissance), couplages électromagnétiques entre les composants de puissance et les éléments de commande, couplages capacitifs de mode commun, rayonnements électromagnétiques ;
- limitations thermiques et mécaniques au niveau de la fiabilité des assemblages et des interconnexions électriques, notamment avec la mise en œuvre de puces de grandes tailles (au-delà d'environ 1 cm²) et brasées sur toute leur face arrière qui est soumise à de fortes dilatations, et également au niveau des fils de bonding avec des efforts électromécaniques à même de produire des « levées » de bonding (décollement) ;
- limitations géométriques : la dissymétrie engendre des difficultés de conception optimale, de répartition et de distribution des potentiels thermiques au niveau du dispositif et des puces ;
- limitations liées au procédé de réalisation : l'assemblage du dispositif est réalisé puce à puce, de manière non collective.

Pour augmenter la compacité des dispositifs électroniques de puissance et les performances CEM de ces dispositifs, il est possible de réaliser les dispositifs sous la forme d'assemblages 3D qui présentent les avantages suivants :
- refroidissement possible sur les deux faces du dispositif électronique de puissance ;
- les potentiels électriques perturbateurs sont confinés par des surfaces métalliques, ce qui permet de réduire les perturbations de mode rayonné.

La réalisation de dispositifs électroniques de puissance sous la forme de structures, ou assemblages, 3D n'est pas aisée étant donné les interconnexions électriques, thermiques et même mécaniques à réaliser, et plusieurs solutions ont été proposées. Cependant, elles sont toutes basées sur des méthodes classiques de packaging, à savoir la brasure ou le bumping (billes de connexion). De telles structures sont disposées horizontalement pour rester conformes aux standards actuels des dispositifs électroniques de puissance, avec une récupération des contacts de manière latérale. Ces assemblages et interconnexions se font puce à puce avec un alignement unitaire. Le document « 3D Integration of Power Seminconductor Devices based on Surface Bump Technology » de M. Mermet-Guyennet et al., Integrated Power Systems (CIPS), 2008, 5th International Conference on, 11-13 mars 2008, pages 1-6, décrit la réalisation de telles structures 3D. De telles structures ne peuvent toutefois être réalisées de manière collective.

Le document US 2013/0062743 A1 décrit un dispositif électronique de puissance 3D comportant des composants de puissance et un système de refroidissement conçus séparément puis assemblés pour former le dispositif. Le refroidissement est réalisé au niveau des deux faces du dispositif via des couches d'isolation disposées entre les couches conductrices et des éléments de refroidissement. Cependant, l'extraction de la chaleur produite par les composants est réalisée uniquement par l'une des faces des composants se trouvant du côté des éléments de refroidissement. De plus, les couches d'isolation augmentent la résistance thermique de l'ensemble et leur disposition au plus près des puces n'a pas d'effet d'étalement de la puissance thermique à dissiper. D'un point de vue des perturbations électromagnétiques, le point milieu, au niveau duquel est généré le principal signal perturbateur, est ramené sur les couches conductrices par des éléments de contact horizontaux. Une configuration similaire à celle d'un dispositif planaire avec une forte capacité parasite de mode commun est donc obtenue. Un circuit de commande est également intégré dans le dispositif, au plus près des transistors. Cependant, ce circuit est soumis à une température importante car il placé près du flux d'évacuation de la chaleur. Son interconnexion est réalisée par bonding, ce qui peut être problématique pour la fiabilité du dispositif lors des cycles thermiques comme précédemment décrit.

Le document « True 3D packaging solution for stacked vertical power devices » de N. Rouger et al., Power Semiconductor Devices and ICs (ISPSD), 2013, 25th International Symposium on, pages 97-100, 26-30 mai 2013, décrit également un dispositif électronique de puissance réalisé sous la forme d'un assemblage 3D disposé horizontalement sur un support. Un tel dispositif électronique de puissance présente les mêmes inconvénients que ceux exposés précédemment.

Enfin, le document US2005/012117 A1 montre un dispositif électronique de puissance comportant :
- un premier composant électronique de puissance réalisé sur un substrat en silicium et dont des électrodes sont disposées au niveau d'une première face principale;
- au moins un élément de contact électrique dont une première face principale est disposée contre la première face principale et comprenant plusieurs portions distinctes électriquement conductrices auxquelles des électrodes du premier composant électronique de puissance sont reliées électriquement ;
dans lequel le premier composant électronique de puissance et l'élément de contact électrique forment ensemble un empilement tel qu'une première face latérale de chacune des portions de l'élément de contact électrique, sensiblement perpendiculaire à la première face principale de l'élément de contact électrique, soit disposée contre au moins une métallisation d'un support formant au moins un contact électrique du premier composant électronique de puissance.

### EXPOSÉ DE L'INVENTION

Un but de la présente invention est de proposer un nouveau type de dispositif électronique de puissance ne présentant pas les inconvénients des dispositifs 2D et 3D exposés précédemment et dont la structure permet sa réalisation de manière collective (et évite ainsi un report puce à puce sur un support pour son assemblage).

Pour cela, selon l'invention, il est proposé un dispositif électronique de puissance selon la revendication 1, un convertisseur statique selon la revendication 8, un procédé de réalisation d'un dispositif électronique de puissance selon la revendication 9 et un procédé de réalisation d'un convertisseur statique selon la revendication 13. En outre, des modes de réalisation préférés de l'invention font l'objet des revendications dépendantes 1-7 et 10-12.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente schématiquement un dispositif électronique de puissance 2D selon l'art antérieur;
- la figure 2 représente schématiquement un dispositif électronique de puissance selon un premier mode de réalisation ;
- la figure 3 représente un schéma électrique de la cellule de commutation du dispositif électronique de puissance représenté sur la figure 2 ;
- la figure 4 représente schématiquement une vue en trois dimensions de deux cellules de commutation d'un dispositif électronique de puissance ;
- les figures 5A à 5G représentent les étapes d'un procédé de réalisation collectif de plusieurs cellules de commutation d'un dispositif électronique de puissance ;
- la figure 6 représente schématiquement plusieurs ensembles de transistors servant à la réalisation de cellules de commutation de dispositifs électroniques de puissance ;
- la figure 7A représente le schéma électrique de deux cellules de commutation réalisées selon un procédé collectif d'un dispositif électronique de puissance ;
- la figure 7B est une vue de face schématique de la tranche de l'empilement formant les deux cellules de commutation de la figure 7A, qui est destinée à être reliée au support ;
- la figure 7C représente la face du support comportant les métallisations destinées à être reliées aux cellules de commutation de la figure 7A ;
- la figure 8A représente le schéma électrique de deux cellules de commutation réalisées selon un procédé collectif d'un dispositif électronique de puissance ;
- la figure 8B est une vue de face schématique de la tranche de l'empilement formant les deux cellules de commutation de la figure 8A, qui est destinée à être reliée au support ;
- la figure 9A représente le schéma électrique de deux cellules de commutation réalisées selon un procédé collectif d'un dispositif électronique de puissance ;
- la figure 9B est une vue de face schématique de la tranche de l'empilement formant les deux cellules de commutation de la figure 9A, qui est destinée à être reliée au support ;
- la figure 9C représente la face du support comportant les métallisations destinées à être reliées aux cellules de commutation de la figure 9A ;
- la figure 10 représente schématiquement un dispositif électronique de puissance selon un deuxième mode de réalisation ;
- la figure 11 représente un schéma électrique d'un exemple de réalisation d'un convertisseur statique ;
- les figures 12A - 12C représentent des étapes de réalisation d'un dispositif électronique de puissance selon un autre exemple de réalisation ;
- la figure 13 représente la face du support comportant les métallisations destinées à être reliées à la cellule de commutation de la figure 12C ;
- la figure 14 représente schématiquement un convertisseur statique selon un autre exemple de réalisation ;
- la figure 15 représente la face du support comportant les métallisations destinées à être reliées aux cellules de commutation du convertisseur de la figure 14 ;
- les figures 16A - 16C représentent des étapes de réalisation d'un dispositif électronique de puissance selon un autre exemple de réalisation qui n'est pas dans la portée des revendications ;
- la figure 17 représente la face du support comportant les métallisations destinées à être reliées à la cellule de commutation de la figure 16C ;
- les figures 18 à 20 représentent des éléments d'un dispositif électronique de puissance, objet de la présente invention, selon une autre variante de réalisation ;
- les figures 21 à 23 représentent d'autres variantes de réalisation d'un dispositif électronique de puissance, objet de la présente invention;
- les figures 24 à 27 représentent d'autres variantes de réalisation d'un dispositif électronique de puissance;
- la figure 28 représente un exemple de réalisation d'un composant de puissance latéral.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

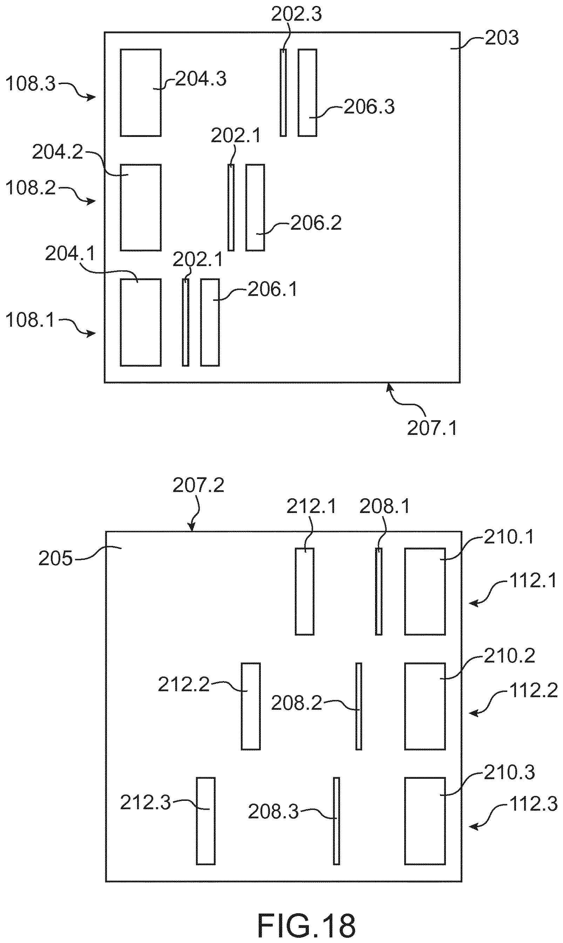

Seuls les modes de réalisation des figures 18-20 et 21-23 sont des modes de réalisation selon l'invention revendiquée.

### EXPOSÉ DÉTAILLÉ DE MODES DE RÉALISATION PARTICULIERS

On se réfère tout d'abord à la figure 2 qui représente un dispositif électronique de puissance 100 selon un premier mode de réalisation.

Le dispositif 100 comporte un support 102 de type circuit imprimé (PCB) ou correspondant à un substrat DBC. Le support 102 comporte une couche diélectrique 103 correspondant par exemple à une couche d'epoxy dans le cas d'un support de type circuit imprimé ou une couche céramique dans le cas d'un substrat DBC. Le support 102 comporte également des métallisations 104 (trois métallisations 104a, 104b et 104c sont visibles sur la figure 2), par exemple en cuivre, disposées sur une face avant de la couche 103.

Un module électronique de puissance formant un assemblage 3D, ou empilement, de composants électroniques de puissance et correspondant à une ou plusieurs cellules de commutation, est disposé sur le support 102. Cet empilement comporte une première couche métallique 106, par exemple en cuivre, sur laquelle sont disposés des premiers composants électroniques de puissance 108, au niveau d'une première face principale de la première couche métallique 106. La première couche métallique 106 forme une première électrode commune aux premiers composants 108 et sur laquelle un potentiel électrique négatif d'alimentation DC- est destiné à être appliqué. L'empilement comporte également une deuxième couche métallique 110, par exemple en cuivre, sur laquelle sont disposés des deuxièmes composants électroniques de puissance 112, au niveau d'une première face principale de la deuxième couche métallique 110. La deuxième couche métallique 110 forme une deuxième électrode commune aux deuxièmes composants 112 et sur laquelle un potentiel électrique positif d'alimentation DC+ est destiné à être appliqué. Les couches 106 et 110 ont par exemple chacune une épaisseur égale à environ 500 µm, ou comprise entre environ 200 et 500µm.

L'empilement comporte également un élément de contact électrique 114, par exemple un cadre métallique (« Lead Frame » métallique) et par exemple en cuivre, formé de plusieurs portions conductrices disjointes reliant électriquement entre eux les premiers et deuxièmes composants 108 et 112. L'élément de contact électrique 114 forme notamment un point milieu de la ou des cellules de commutation du dispositif 100. Les composants 108, 112 sont disposés contre deux faces principales opposées de l'élément 114. L'élément 114 forme également la borne de sortie de la ou des cellules de commutation. Les liaisons électriques entre les composants 108, 112 et l'élément 114 sont par exemple réalisées par des collages cuivre-cuivre lorsque l'élément 114 comporte du cuivre et que les électrodes des composants 108, 112 comportent du cuivre.

Les composants 108 et 112 sont ici des composants verticaux disposés perpendiculairement aux premières faces principales des couches 106, 110 au niveau desquelles les composants sont disposés.

L'empilement est disposé verticalement sur le support 102, c'est-à-dire est relié et solidarisé aux métallisations 104 au niveau de sa tranche, c'est-à-dire au niveau d'un premier côté ou d'une première face latérale de l'empilement. Ainsi, une première face latérale de la première couche 106 qui est perpendiculaire à la première face principale de la première couche 106 est reliée électriquement à la métallisation 104a, une première face latérale de la deuxième couche 110 qui est perpendiculaire à la première face principale de la deuxième couche 110 est reliée électriquement à la métallisation 104b, et une première face latérale de l'élément 114, c'est-à-dire une première face latérale de chacune des portions électriquement conductrices formant l'élément 114, qui est perpendiculaire aux faces principales de l'élément 114, est reliée électriquement à plusieurs métallisations 104 dont la métallisation 104c. Le nombre de portions électriquement conductrices que comporte l'élément 114, et donc le nombre de métallisations 104 auxquelles l'élément 114 est relié, dépend notamment de la nature et du nombre de composants électroniques de puissance formant la ou les cellules de commutation. L'agencement vertical de l'empilement, c'est-à-dire la disposition des composants électroniques de puissance 108, 112 perpendiculairement au support 102, implique que les composants électroniques de puissance de l'empilement sont disposés horizontalement (par rapport à la face avant du support 102 sur laquelle l'empilement est disposé) dans le dispositif 100. Les liaisons électriques entre les couches 106, 110 et les métallisations 104a, 104b, ainsi que la liaison électrique entre l'élément 114 et les métallisations auxquelles l'élément 114 est relié (dont la métallisation 104c) sont par exemple réalisées par brasure.

Un condensateur de découplage 116 est disposé au niveau d'un deuxième côté, ou deuxième face latérale, de l'empilement, c'est-à-dire au niveau de deuxièmes faces latérales des couches 106, 110, opposées aux premières faces latérales disposées du côté du support 102. Ce condensateur 116 comporte deux électrodes chacune reliée électriquement à l'une des deux couches 106, 110.

Le dispositif 100 comporte également un circuit de commande 118, ou driver, apte à commander la commutation de la ou des cellules de commutation de l'empilement et relié aux composants 108, 112 par des liaisons électriques (non visibles sur la figure 2) qui traversent le support 102. Ce circuit 118 peut comporter des composants électroniques basse tension, par exemple des transistors CMOS. Le dispositif 100 peut comporter également d'autres composants électroniques, par exemple des éléments passifs tels qu'une ou plusieurs inductances, disposés sur la face arrière du support 102.

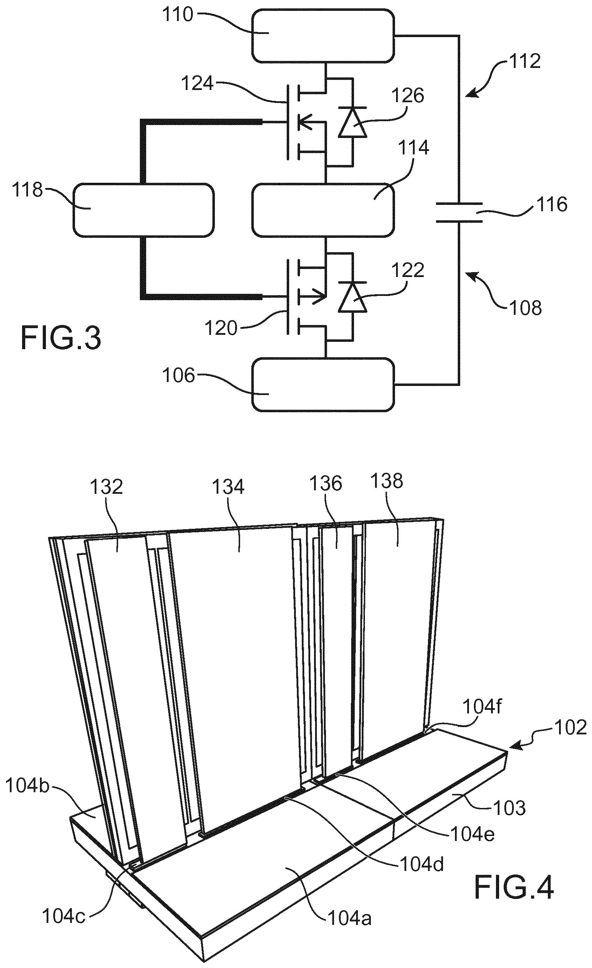

Le dispositif 100 correspond ici à une cellule de commutation dont le schéma électrique selon un premier exemple de réalisation est représenté sur la figure 3. Les premiers composants 108 comportent un premier transistor de puissance de type PMOS 120 dont le drain est relié à la première couche métallique 106 et dont la source est reliée à l'élément 114, et une première diode antiparallèle de puissance 122 reliée entre la source et le drain du premier transistor 120. Les deuxièmes composants 112 comportent un deuxième transistor de puissance de type NMOS 124 dont le drain est relié à la deuxième couche métallique 110 et dont la source est reliée à l'élément 114, et une deuxième diode antiparallèle de puissance 126 reliée entre la source et le drain du deuxième transistor 124. Les grilles des transistors 120, 124 sont reliées au circuit 118 qui est apte à commander la commutation des transistors 120, 124.

La première diode antiparallèle est généralement intégrée au premier transistor de puissance et/ou la deuxième diode antiparallèle est généralement intégrée au deuxième transistor de puissance. Il est toutefois possible que la ou les diodes antiparallèles soient des composants distincts des transistors.

Le dispositif 100 comporte en outre des dissipateurs thermiques 128, 130 disposés contre des deuxièmes faces principales des couches 106 et 110, opposées aux premières faces principales sur lesquelles sont disposés les composants 108, 112. Ces dissipateurs 128, 130 permettent de dissiper latéralement la chaleur produite par les composants 108, 112 (la dissipation latérale de la chaleur est représentée symboliquement par des flèches horizontales sur la figure 2).

Du fait que l'empilement est relié électriquement aux métallisations 104 au niveau d'un côté ou d'une face latérale, c'est-à-dire est disposé verticalement sur le support 102 ou perpendiculairement au support 102, la surface d'occupation de l'empilement sur le support 102 est réduite par rapport aux assemblages 3D de l'art antérieur. Cette disposition particulière verticale de l'empilement formant la cellule de commutation permet d'obtenir un gain de place sur le support 102 par rapport à un assemblage nécessitant des contacts électriques latéraux sur lesquels les signaux de sortie sont obtenus.

Avec une telle structure, le condensateur 116 réalise un filtrage des perturbations de mode différentiel générées par les commutations des transistors 120 et 124, ce filtrage étant réalisé au plus près de ces transistors et donc de la source de ces perturbations. La maille de circulation du courant entre le condensateur 116 et les composants 108, 112 formant la cellule de commutation est dont réduite au maximum, ce qui réduit les perturbations de mode différentiel dans le dispositif 100.

De plus, cette structure permet aux éléments se trouvant de part et d'autre des faces latérales de l'empilement (le condensateur 116 et le circuit 118 sur l'exemple de la figure 2) de n'être pas ou peu soumis à la chaleur évacuée par les dissipateurs 128, 130. Le circuit 118 est également disposé au plus près des transistors de la cellule de commutation qui, de part leur disposition horizontale, sont disposés perpendiculairement à ce circuit 118. Cette disposition permet de ne pas créer de couplages électromagnétiques entre le circuit 118 et les interrupteurs (ici les transistors) de la cellule de commutation.

En outre, la réalisation des composants 108, 112 sous la forme d'un empilement 3D permet, par rapport à un assemblage 2D, de supprimer les perturbations de mode rayonné.

Dans l'exemple précédemment décrit, le dispositif 100 comporte une cellule de commutation formée de deux transistors MOS de puissance chacun pouvant être optionnellement couplé à une diode antiparallèle. Ces deux transistors peuvent être de types complémentaires (NMOS et PMOS) ou du même type NMOS.

En variante, la cellule de commutation peut être réalisée avec des composants électroniques de puissance autres que ceux précédemment décrits, par exemple au moins un transistor NMOS de puissance (correspondant par exemple au deuxième composant 112) relié à une diode de puissance (correspondant par exemple au premier composant 108).

Une cellule de commutation comporte au moins deux interrupteurs fonctionnant de manière complémentaire, chaque interrupteur pouvant être commandé (transistor MOS, JFET, transistor bipolaire, IGBT, thyristor, etc.) ou non (diode de puissance). Les deux interrupteurs de la cellule de commutation peuvent chacun correspondre à un interrupteur commandé couplé à une diode antiparallèle.

Les composants 106, 108 peuvent correspondre à différents types de composants tels que des diodes, des transistors de type JFET, MOSFET, des transistors IGBT, des thyristors, et par exemple à base de silicium, de carbure de silicium, de GaN ou de diamant.

Le dispositif 100 peut comporter plusieurs cellules de commutation similaires à celle précédemment décrite, réalisées sur le support 102 et reliées électriquement entre elles en formant un convertisseur statique (hacheur, onduleur, redresseur ou gradateur) ou un convertisseur polyphasé (hacheur entrelacé par exemple).

La figure 4 représente une vue en trois dimensions de deux cellules de commutation similaires à celle précédemment décrite en liaison avec les figures 2 et 3, et en coupe au niveau de l'élément 114. L'élément 114 comporte une première portion 132 en contact avec les grilles des deux transistors d'une première des deux cellules de commutation et disposée sur la métallisation 104c du support 102, au niveau d'une de ses faces latérales. L'élément 114 comporte également une deuxième portion 134 en contact avec les sources des transistors de la première des deux cellules de commutation et comportant l'une de ses faces latérales disposée sur une métallisation 104d du support 102. L'élément 114 comporte deux autres portions 136 et 138 reliées de manière analogue aux transistors de la deuxième des deux cellules de commutation et disposées sur d'autres métallisations 104e et 104f.

Dans la configuration représentée sur la figure 4, chaque transistor comporte des régions de grille et de source disposées l'une à côté de l'autre et de forme sensiblement rectangulaire. Les portions 132, 134, 136, 138 de l'élément 114 sont disposées les unes à côté des autres et sont également de forme sensiblement rectangulaire.

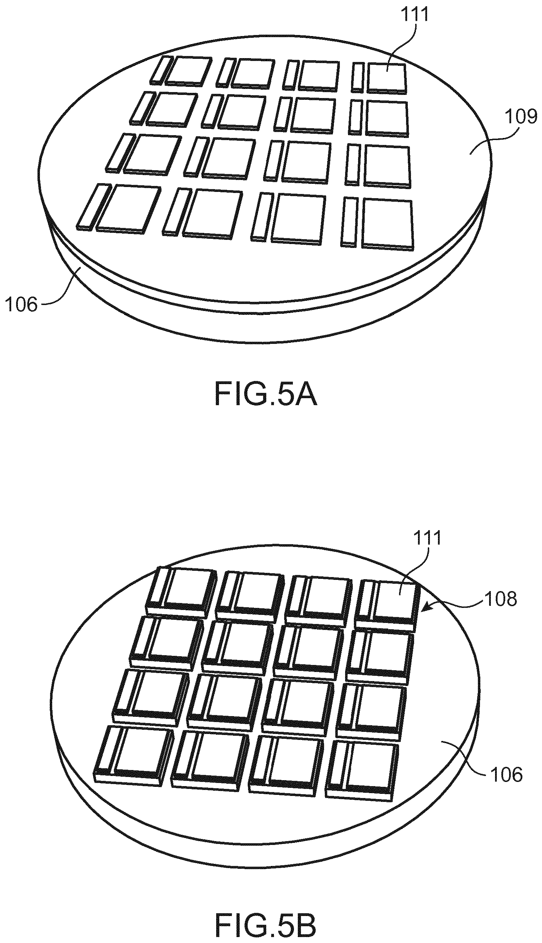

Le dispositif 100 est avantageusement réalisé par des étapes de mises en œuvre collective réalisées à l'échelle du substrat et permettant la réalisation simultanée de plusieurs cellules de commutation sous forme d'empilements destinés à être disposés verticalement sur un support métallisé. Un tel procédé est décrit ci-dessous en liaison avec les figures 5A à 5G.

Les premiers composants 108 de plusieurs cellules de commutation, par exemple des transistors PMOS, sont réalisés à partir d'un premier substrat de silicium 109 reporté sur la première couche métallique 106, ici en cuivre, formant une électrode commune reliée aux drains des transistors PMOS. Des métallisations en cuivre 111, avantageusement de forme rectangulaire, sont réalisées sur les grilles et sources des transistors PMOS (figure 5A).

Comme représenté sur la figure 5B, une étape d'îlotage comprenant la gravure profonde du premier substrat de silicium 109 jusqu'à atteindre la première couche métallique 106, est ensuite mise en œuvre afin que les zones actives des transistors PMOS soient isolées les unes des autres. Cette étape permet de garantir la tenue en tension des premiers composants 108 ainsi que l'isolation entre eux au niveau des régions de grille et de source.

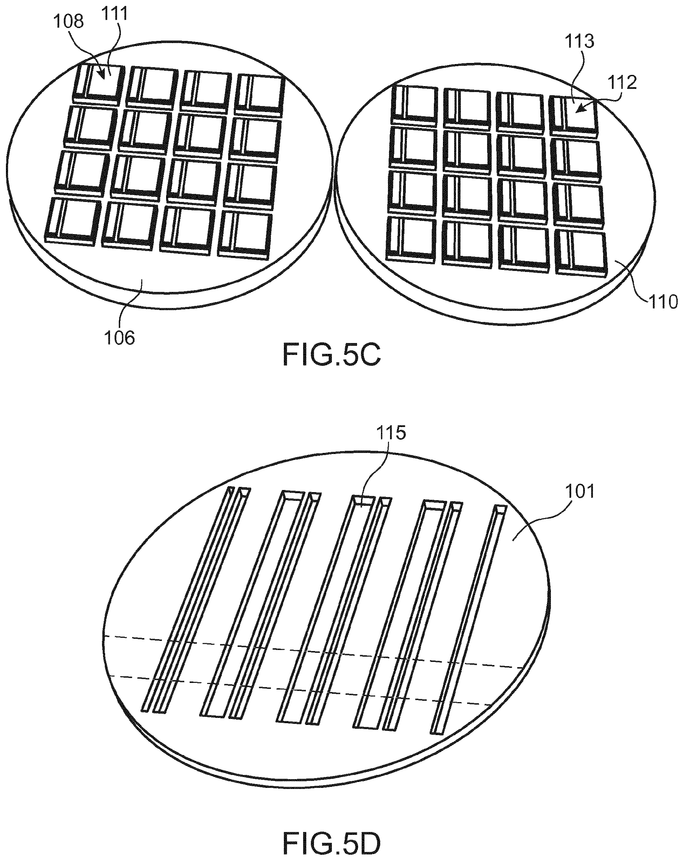

Parallèlement à la réalisation des premiers composants 108, les deuxièmes composants 112, par exemple des transistors NMOS, sont réalisés sur un deuxième substrat de silicium reporté que la deuxième couche métallique 110, également en cuivre, de manière analogue aux premiers composants 108. Des métallisations en cuivre 113 sont réalisées sur les grilles et sources des transistors NMOS. Une étape d'îlotage comprenant la gravure profonde du deuxième substrat de silicium jusqu'à atteindre la deuxième couche métallique 110 est ensuite mise en œuvre afin que les zones actives des transistors NMOS soient isolés les unes des autres (figure 5C).

Les composants 108, 112 sont des composants verticaux par exemple réalisés sur une hauteur comprise entre environ 30 µm et 1 mm. Les substrats de semi-conducteur utilisés pour réaliser les composants 108, 112 peuvent être amincis ou non, et peuvent être à base d'un semi-conducteur autre que le silicium selon la technologie des composants 108, 112.

Une couche métallique structurée 101, destinée à former les éléments de contact électrique 114 des cellules de commutation, est ensuite réalisée, par exemple par usinage d'un disque de cuivre de diamètre égal à celui des wafers utilisés pour la réalisation des composants 108, 112 (par exemple égal à environ 200 mm) et d'épaisseur par exemple égale à 300 µm, selon les motifs des composants afin de pouvoir séparer par exemple les potentiels de source et de grille des transistors (figure 5D). Cet usinage forme par exemple des évidements 115 de forme rectangulaire à travers la couche 101, ces évidements 115 permettant de séparer, dans chaque élément de contact électrique 114, les électrodes des composants sur un vecteur de composants qui sera découpé ultérieurement une fois l'assemblage réalisé entre cette couche métallique structurée 101 et les composants 108, 112 précédemment réalisés. Cette découpe sera par exemple réalisée selon un chemin sensiblement perpendiculaire à la plus grande dimension des rectangles formés par les évidements 115, comme indiqué en pointillés sur la figure 5D.

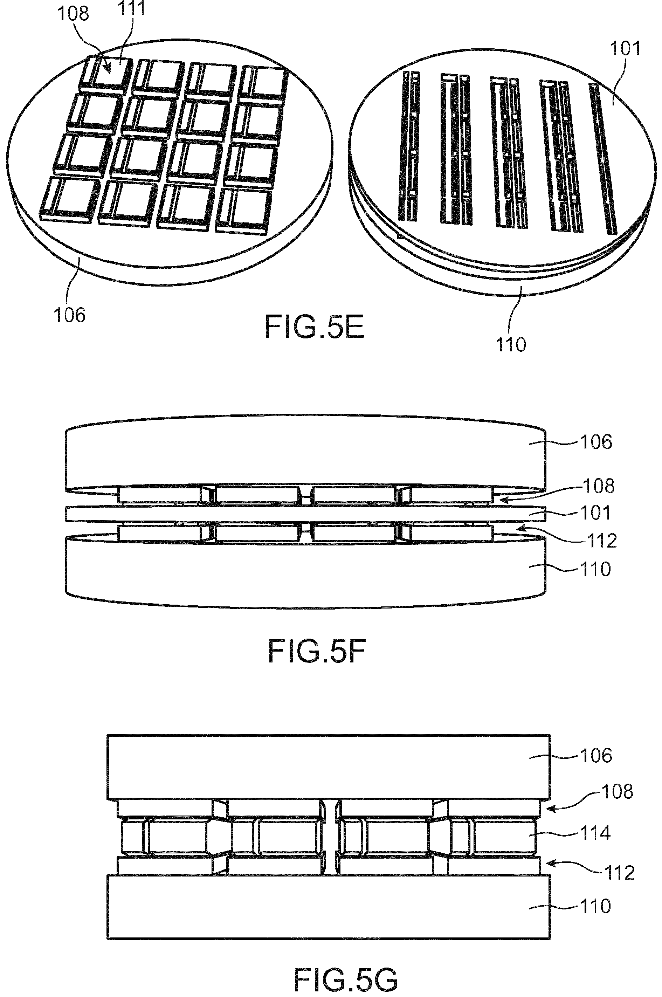

Comme représenté sur la figure 5E, la couche métallique structurée 101 est ensuite reportée, au niveau d'une de ses deux faces principales, sur l'un des ensembles des premiers ou des deuxièmes composants 108, 112 (sur les deuxièmes composants 112 sur l'exemple de la figure 5E). Les autres composants sont ensuite assemblés sur l'autre face principale de la couche 101 (figure 5F).

On réalise ainsi un assemblage plaque à plaque via un collage métallique par thermo-compression ou collage direct sur les deux faces principales opposées de la couche 101, c'est-à-dire des éléments 114. La structure ainsi obtenue correspond à plusieurs cellules de commutation réalisées selon un procédé collectif pleine plaque. La couche 101 réalise l'interconnexion pleine plaque des potentiels situés au milieu de l'empilement 3D obtenu. L'empilement obtenu est symétrique par rapport à la couche 101, et donc par rapport aux éléments 114, pour favoriser la répartition des contraintes mécaniques engendrées par les différences entre les coefficients de dilatation thermique du silicium et du cuivre.

L'assemblage ainsi obtenu forme les cellules de commutation utilisées pour la réalisation de dispositifs électroniques de puissance 100 tels que précédemment décrits.

Les cellules de commutation sont ensuite découpées individuellement ou sous la forme d'ensembles, ou vecteurs, de cellules de commutation disposées les unes à côté des autres. La figure 5G représente par exemple un vecteur de quatre cellules de commutation (ou quatre bras) comportant chacune un transistor PMOS et un transistor NMOS. Un tel vecteur de quatre cellules de commutation est par exemple utilisé pour la réalisation d'un dispositif 100 correspondant à un convertisseur entrelacé.

Etant donné que la découpe est réalisée après l'assemblage des substrats comportant les composants 108, 112 avec la couche 101, les flancs, c'est-à-dire les faces latérales, des différents éléments de l'ensemble découpé sont alignés et peuvent ainsi être utilisés pour réaliser les interconnexions entre la ou les cellules de commutation et le support 102, les contacts de la ou des cellules de commutation étant récupérés sur l'une des tranches de l'ensemble découpé.

Les empilements comportant chacun une ou plusieurs cellules de commutation sont solidarisés aux métallisations 104 du support 102 par exemple par brasure. Les métallisations 104 ont une épaisseur par exemple comprise entre environ 10 µm et 300 µm, une largeur par exemple comprise entre environ 300 µm et 500 µm, et les métallisations auxquelles sont solidarisées les portions de l'élément 114 sont par exemple espacées des métallisations auxquelles sont solidarisés les couches 106, 110 d'une distance comprise entre environ 50 µm et 100 µm. Le ou les condensateurs de découplage 116 sont ensuite assemblés sur le ou les empilements réalisés, par exemple par brasure. Enfin, le ou les circuits de commande 118 sont reportés sur la face arrière du support 102.

Le design des composants électroniques de puissance utilisés est adapté à la connexion par la tranche de l'empilement réalisé. Ainsi, dans les exemples précédemment décrits en liaison avec les figures 2 à 5, les transistors utilisés comportent chacun, dans un plan parallèle aux faces principales des couches 106, 110, une grille qui n'est pas totalement entourée par la source. Les motifs de la grille et de la source de chaque transistor correspondent par exemple à deux rectangles disposés l'un à côté de l'autre. Lors de la réalisation collective de ces transistors, préalablement à la découpe de la structure, toutes les grilles des transistors disposés sur une même colonne peuvent être reliées électriquement entre elles par une portion métallique de la couche 101, et toutes les sources de ces transistors peuvent être reliées électriquement entre elles par une autre portion métallique de la couche 101. Ce n'est qu'une fois l'empilement assemblé que les transistors sont alors découpés et se retrouvent isolés les uns des autres.

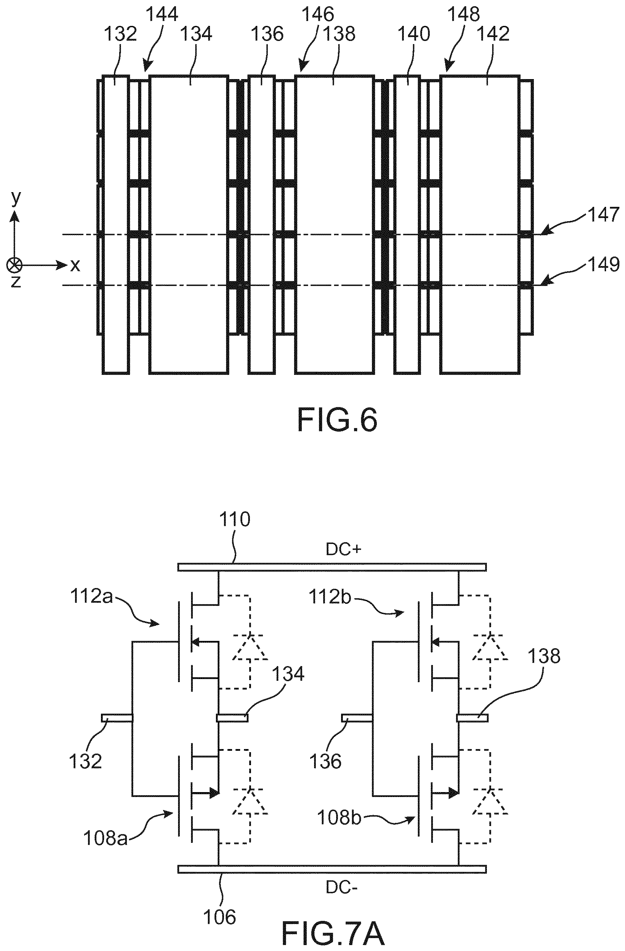

La figure 6 représente schématiquement plusieurs ensembles 144, 146 et 146 de transistors réalisés collectivement sur un même substrat, les transistors de chacun de ces ensembles 144, 146 et 148 étant disposés en colonne. Chacune des portions métalliques 132 à 142 de la couche métallique structurée 101 relie les grilles ou les sources des transistors d'un des ensembles 144, 146 et 148. Les traits pointillés 147, 149 représentés sur la figure 6 correspondent à des traits de découpe permettant d'isoler les transistors de chacun des ensembles les uns par rapport aux autres. Sur l'exemple de la figure 6, les découpes réalisées forment des ensembles de trois transistors disposés les uns à côté des autres. Le nombre de transistors de chaque ensemble est choisi en fonction des besoins pour réaliser le dispositif 100. Pour la réalisation d'un convertisseur, par exemple polyphasé, la découpe des ensembles de transistors peut être réalisée en choisissant un nombre de transistors disposés les uns à côté des autres selon l'axe X représenté sur la figure 6 en fonction du nombre de cellules de commutation du convertisseur. De plus, au sein de chaque ensemble de transistors, le nombre de transistors conservés dans chaque colonne, c'est-à-dire selon l'axe Y représenté sur la figure 6, et dont les grilles et sources sont reliées par l'une des portions métalliques 132-134, peut être choisi en fonction du calibre du courant du convertisseur souhaité.

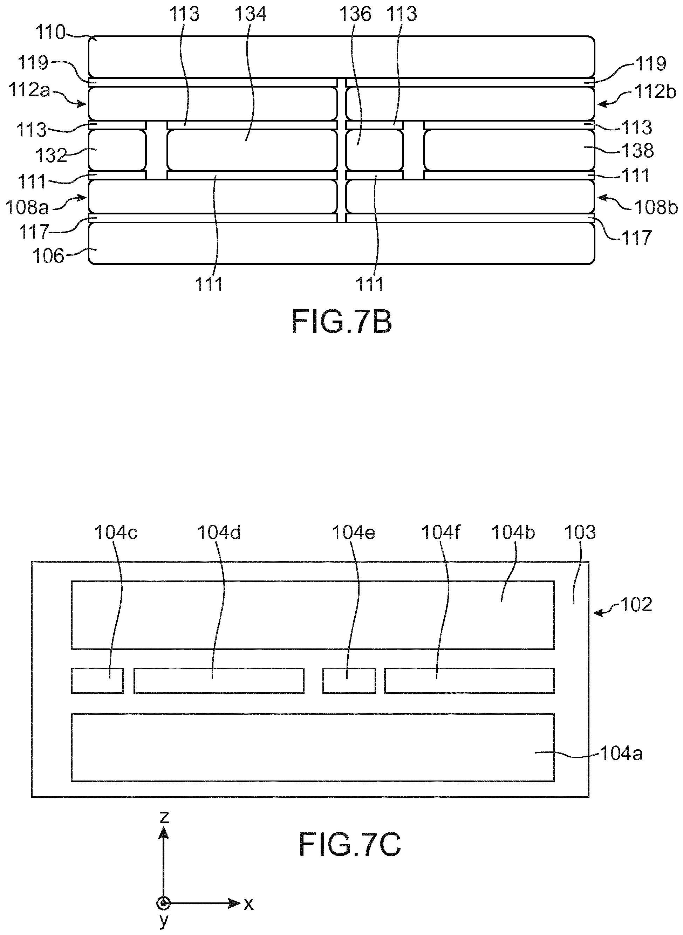

La figure 7A représente le schéma électrique de deux cellules de commutation réalisées selon un procédé collectif tel que précédemment décrit en liaison avec les figures 5A à 5G, selon un premier exemple de réalisation, et par exemple destinées à faire partie d'un même dispositif électronique de puissance 100. La figure 7B est une vue de face schématique de la tranche de l'empilement formant ces deux cellules de commutation et qui est destinée à être reliée au support 102. La figure 7C représente la face du support 102 comportant les métallisations 104 destinées à être reliées aux cellules de commutation.

La première cellule de commutation comporte un transistor de puissance de type PMOS 108a couplé à un transistor NMOS 112a de manière analogue aux transistors formant la cellule de commutation précédemment décrite en liaison avec la figure 3. Le potentiel négatif d'alimentation DC- des cellules de commutation est appliqué sur le drain du transistor PMOS 108a via la première couche métallique 106 qui est reliée électriquement au drain du transistor PMOS 108a par l'intermédiaire d'une métallisation 117. La grille et la source du transistor PMOS 108a sont reliées respectivement à la grille et à la source du transistor NMOS 112a via les portions métalliques 132 et 134 de l'élément de contact électrique 114. La grille et la source du transistor PMOS 108a sont reliées respectivement aux portions 132 et 134 de l'élément 114 par les métallisations 111. De même, la grille et la source du transistor NMOS 112a sont reliées respectivement aux portions 132 et 134 de l'élément 114 par les métallisations 113. Le potentiel positif d'alimentation DC+ des cellules de commutation est appliqué sur le drain du transistor NMOS 112a via la deuxième couche métallique 110 qui est reliée au drain du transistor NMOS 112a par l'intermédiaire d'une métallisation 119.

La deuxième cellule de commutation comporte un transistor de puissance de type PMOS 108b couplé à un transistor NMOS 112b de manière analogue aux transistors formant la première cellule de commutation précédemment décrite. Le potentiel négatif d'alimentation DC- est appliqué sur le drain du transistor PMOS 108b via la première couche métallique 106 (qui est commune aux deux cellules de commutation) qui est reliée au drain du transistor PMOS 108b par l'intermédiaire d'une métallisation 117. La grille et la source du transistor PMOS 108b sont reliées respectivement à la grille et la source du transistor NMOS 112b via les portions métalliques 136 et 138 de l'élément 114. La grille et la source du transistor PMOS 108b sont reliées respectivement aux portions 136 et 134 de l'élément 114 par les métallisations 111. De même, la grille et la source du transistor NMOS 112b sont reliées respectivement aux portions 136 et 138 de l'élément 114 par les métallisations 113. Le potentiel positif d'alimentation DC+ est appliqué sur le drain du transistor NMOS 112b via la deuxième couche métalliques 110 (commune aux deux cellules de commutation) qui est reliée au drain du transistor NMOS 112b par l'intermédiaire d'une métallisation 119.

En variante, un ou plusieurs des transistors 108a, 108b, 112a et 112b peuvent être couplés à des diodes antiparallèles (de telles diodes sont représentées en pointillés sur la figure 7A).

La face de l'empilement représentée sur la figure 7B est reportée sur les métallisations 104 du support 102 représentées sur la figure 7C. La longueur (dimension selon l'axe X représenté sur la figure 7C) occupée par les métallisations 104 sur le support 102 est par exemple comprise entre environ 100 µm et 1 mm pour le plot de grille et 2 mm et 5 mm pour le plot de source, et par exemple égal à environ 1 cm pour le support 102.

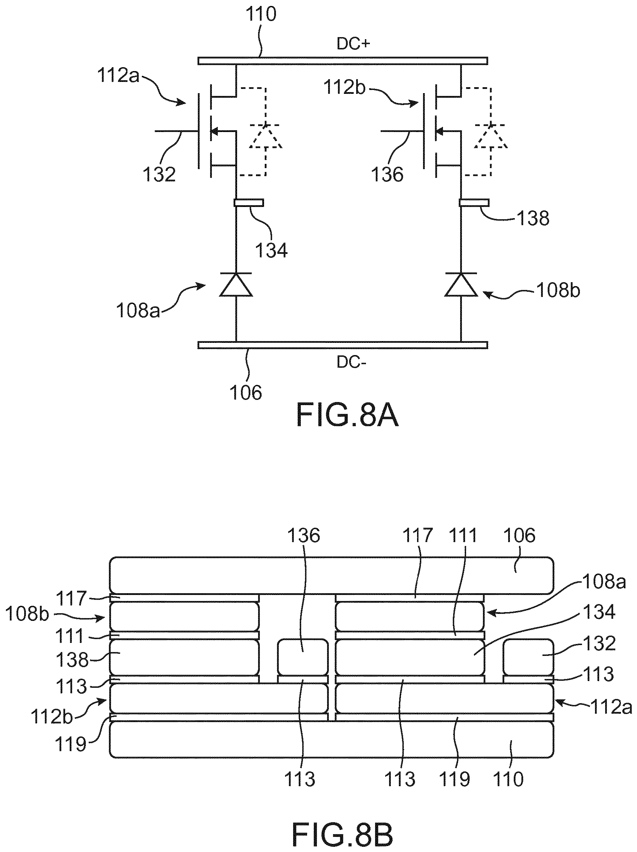

La figure 8A représente le schéma électrique de deux cellules de commutation réalisées selon le procédé collectif précédemment décrit en liaison avec les figures 5A à 5G, selon un deuxième exemple de réalisation et par exemple destinée à faire partie d'un même dispositif électronique de puissance 100. La figure 8B est une vue de face de la tranche de l'empilement formant ces deux cellules de commutation et qui est destinée à être reliée au support 102.

La première cellule de commutation comporte une diode de puissance 108a couplée, via sa cathode, à un transistor NMOS 112a. Le potentiel négatif d'alimentation DC- est appliqué sur l'anode de la diode 108a via la première couche métallique 106 qui est reliée à l'anode de la diode 108a par l'intermédiaire d'une métallisation 117. La cathode de la diode 108a est reliée à la source du transistor NMOS 112a via la portion métallique 134 de l'élément 114. La cathode de la diode 108a est reliée à la portion 134 par l'une des métallisations 111. La grille et la source du transistor NMOS 112a sont reliées respectivement aux portions 132 et 134 de l'élément 114 par les métallisations 113. Le potentiel positif d'alimentation DC+ est appliqué sur le drain du transistor NMOS 112a via la deuxième couche métallique 110 qui est reliée au drain du transistor NMOS 112a par l'intermédiaire d'une métallisation 119.

La deuxième cellule de commutation comporte une diode de puissance 108b couplée, via sa cathode, à un transistor NMOS 112b. Le potentiel négatif d'alimentation DC- est appliqué sur l'anode de la diode 108b via la première couche métallique 106 qui est reliée à l'anode de la diode 108b par l'intermédiaire d'une métallisation 117. La cathode de la diode 108b est reliée à la source du transistor NMOS 112b via la portion 134 de l'élément 114. La cathode de la diode 108b est reliée à la portion 134 de l'élément 114 par l'une des métallisations 111. La grille et la source du transistor NMOS 112b sont reliées respectivement aux portions 132 et 134 de l'élément 114 par les métallisations 113. Le potentiel positif d'alimentation DC+ est appliqué sur le drain du transistor NMOS 112b via la deuxième couche métallique 110 qui est reliée au drain du transistor NMOS 112b par l'intermédiaire d'une métallisation 119.

Un ou plusieurs des transistors 112a et 112b peuvent être couplés à des diodes antiparallèles (représentées en pointillés sur la figure 8A).

Dans chacune des cellules de commutation, la diode est réalisée telle que sa surface (dans le plan du substrat sur lequel elle est réalisée) soit proche de celle du transistor NMOS de la cellule de commutation dont elle fait partie. Cela permet de faciliter l'assemblage de l'empilement sur le support 102 grâce par exemple aux dimensions similaires de la métallisation 111 reliant la cathode de la diode à l'élément 114 et de la métallisation 113 reliant la source du transistor NMOS à l'élément 114, comme représenté sur la figure 8B. Cela implique un surdimensionnement de la diode vis-à-vis du transistor (pour un même calibre en courant, la diode, qui est un composant bipolaire, a une surface plus petite que le transistor MOS, qui lui est un composant unipolaire).

La face de l'empilement représentée sur la figure 8B est reportée sur les métallisations 104 du support 102 qui sont configurées de manière analogue à celles représentées sur la figure 7C.

Dans l'exemple représenté sur la figure 8B, les côtés des portions 132 et 136 se trouvant en regard de la première couche métallique 106 ne sont pas reliés mécaniquement à cette première couche 106. Toutefois, du fait que la surface des grilles des transistors 112a, 112b est inférieure à celle des sources des transistors 112a, 112b, cela n'impact pas la bonne répartition des forces de thermo-compression lors de l'assemblage réalisé pour former ces empilements.

Ce deuxième exemple de réalisation est avantageusement mis en œuvre en utilisant des composants de même type, par exemple des composants bipolaires tels que des diodes PN et des transistors IGBT, ou des composants unipolaires tels que des transistors MOSFET ou JFET et des diodes Schottky à base de SiC.

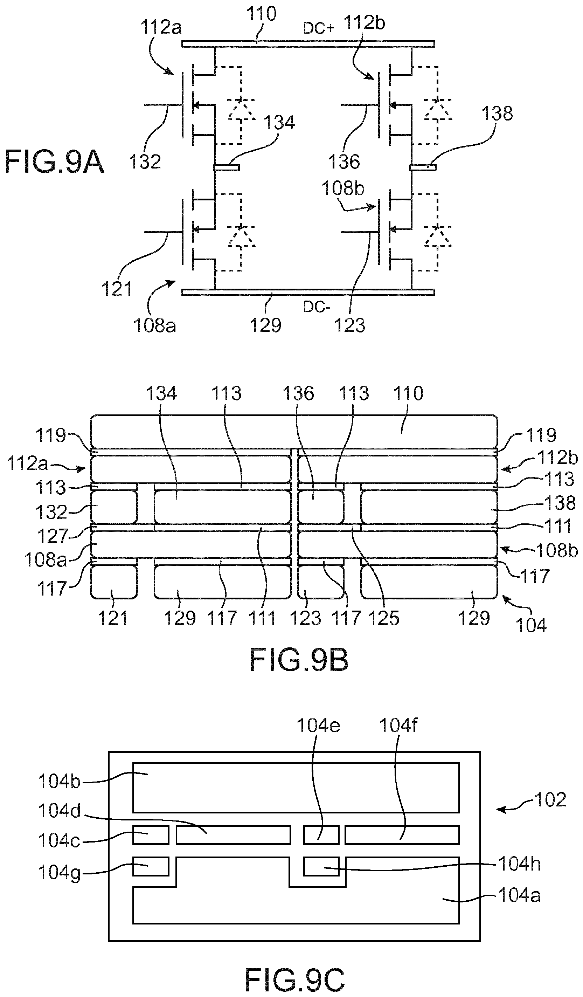

La figure 9A représente le schéma électrique de deux cellules de commutation réalisées selon le procédé collectif précédemment décrit en liaison avec les figures 5A à 5G, selon un troisième exemple de réalisation, et par exemple destinées à faire partie d'un même dispositif électronique de puissance 100. La figure 9B est une vue de face de la tranche de l'empilement formant ces deux cellules de commutation qui est destinée à être reliée au support 102, et la figure 9C représente la face du support 102 comportant les métallisations 104 destinées à être reliées aux cellules de commutation.

Dans ce troisième exemple de réalisation, chacun des composants 108a, 108b, 112a, 112b correspond à un transistor NMOS, chaque cellule de commutation étant formée par deux transistors NMOS couplés l'un avec l'autre. Dans cette configuration, la commande des transistors au sein d'une cellule de commutation n'est pas commune (contrairement au cas précédemment décrit en liaison avec les figures 7A - 7C) car les transistors ne sont pas de types complémentaires. Ce troisième exemple de réalisation fait donc appel à deux électrodes supplémentaires reliées aux grilles des transistors 108a et 108b. Un tel assemblage peut être réalisé en faisant appel à deux éléments de contact électrique distincts. L'un des deux éléments, correspondant à l'élément 114, est disposé entre les premiers et deuxièmes composants et comporte les portions 132, 134, 136 et 138 comme dans le premier exemple de réalisation. Les grilles des transistors 108a, 108b ne sont pas reliées électriquement aux portions 132 et 136 mais sont isolées électriquement de celles-ci pas des portions diélectriques 125 et 127, par exemple à base d'oxyde. L'autre des deux éléments de contact électrique forme la première couche métallique 106 et comporte des portions 121, 123 et 129 isolées les unes des autres et reliées aux sources et grilles des transistors 108a, 108b.

Un ou plusieurs des transistors 108a, 108b, 112a et 112b peuvent être couplés à des diodes antiparallèles (représentées en pointillés sur la figure 9A).

La face de l'empilement représentée sur la figure 9B est reportée sur les métallisations 104 du support 102 représentées sur la figure 9C et qui comportent, par rapport à celles précédemment décrites en liaison avec la figure 7C, deux métallisations 104g et 104h supplémentaires destinées à être reliées aux grilles des transistors 108a, 108b.

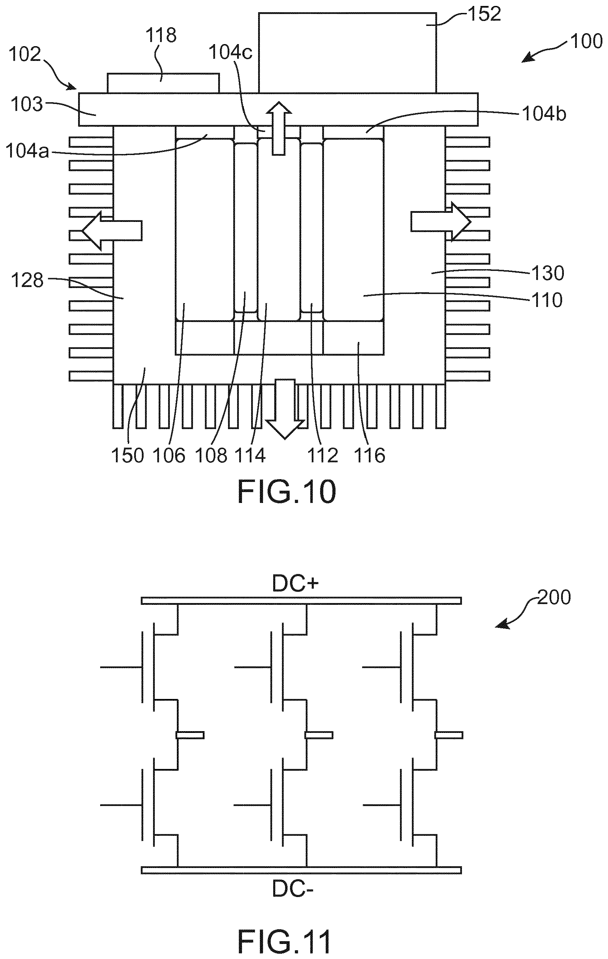

La figure 10 représente un dispositif électronique de puissance 100 selon un deuxième mode de réalisation.

Comme dans le premier mode de réalisation, le dispositif 100 comporte le support 102, les métallisations 104, les couches métalliques 106, 110, les composants 108, 112, l'élément 114, le condensateur 116 et le circuit 118.

Dans ce deuxième mode de réalisation, les dissipateurs thermiques 128, 130 disposés contre les couches 106, 110 forment un boîtier dans lequel l'empilement formant la ou les cellules de commutation est disposé. Ce boîtier comporte également une partie 150 correspondant à un dissipateur thermique supplémentaire et formant le fond du boîtier. Cette partie 150 est disposée contre le condensateur 116 et contribue à la dissipation de la chaleur produite par les composants 108, 112. Les dissipateurs 128, 130 et 150 forment un bloc de dissipation de chaleur jouant également un rôle de maintien mécanique de l'empilement sur le support 102.

Des éléments 152 servant à la conversion d'énergie réalisée par le module 100 sont disposés sur la face arrière du support 102. Ces éléments 152 sont par exemple des inductances et/ou des éléments de transformation d'énergie (entrelacés ou non) et sont reliés aux composants 108, 112 par l'intermédiaire d'interconnexions de puissance (non visibles sur la figure 10) réalisées à travers le support 102. La disposition des éléments 152 au niveau de la face arrière du support 102 et non au sein de l'empilement permet de réduire la surface du point milieu qui est une source de perturbations de mode commun.

D'autres éléments de commande, par exemple de type DSP ou FPGA, peuvent être disposés au niveau de la face arrière du support 102.

Un tel boîtier de type press-pack peut être avantageusement utilisé pour la réalisation de convertisseurs de fortes puissances.

Quel que soit le mode de réalisation du dispositif 100, il est possible d'intégrer un circuit de circulation d'un fluide caloporteur, notamment lorsque le dispositif 100 comporte des ensembles de plusieurs cellules de commutation.

En outre, un isolant électrique peut être disposé entre les deuxièmes faces principales des couches 106, 110 et les dissipateurs thermiques 128, 130, notamment pour le deuxième mode de réalisation précédemment décrit et lorsque les dissipateurs thermiques 128, 130 sont électriquement conducteurs, afin de ne pas courtcircuiter les composants 108, 112.

La figure 11 représente le schéma électrique d'un exemple de réalisation d'un convertisseur statique 200 réalisé à partir d'un dispositif électronique de puissance tel que précédemment décrit. Ce convertisseur statique 200 correspond ici à un onduleur triphasé formé par un dispositif électronique de puissance comportant trois cellules de commutation (chaque cellule formant un bras du convertisseur), et par exemple utilisé pour l'alimentation et la commande de moteurs triphasés. Chaque bras formé par deux transistors, par exemple comme dans les exemples précédemment décrits en liaison avec les figures 3, 7 ou 9.

Dans les modes et exemples de réalisation précédemment décrits, les composants du dispositif 100 correspondent à des composants de puissance verticaux, ou à structure verticale, c'est-à-dire des composants dans lesquels le courant électrique circule de manière verticale, sensiblement perpendiculairement aux substrats sur lesquels ces composants sont réalisés. En variante, les composants peuvent correspondre à des composants de puissance latéraux, ou à structure latérale, par exemple en silicium sur SOI (Silicon On Insulator) de type LDMOS (Lateral Diffused MOS) ou des transistors à base de GaN, par exemple de type HEMT (« High Electron Mobility Transistor »), c'est-à-dire des composants dans lesquels le courant électrique circule sensiblement parallèlement aux substrats à partir desquels ces composants sont réalisés.

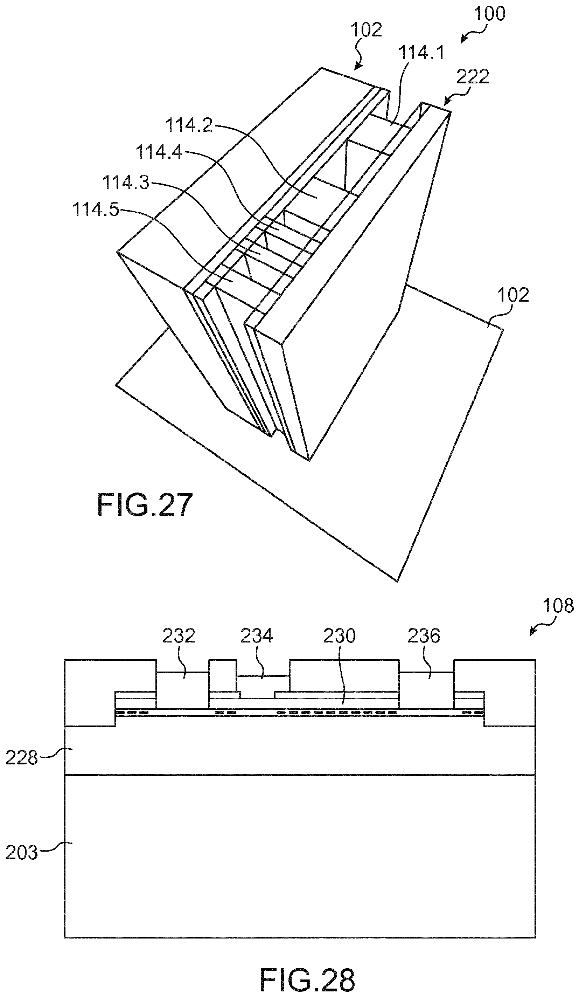

Un exemple de réalisation d'un tel composant de puissance à structure latérale est représenté sur la figure 28. Sur cette figure, le composant de puissance latéral correspond à un transistor de puissance 108 de type HEMT à base de GaN. Ce transistor 108 est formé sur un substrat de silicium 203 dont l'épaisseur est par exemple comprise entre environ 725 µm et 1000 µm. La partie active du transistor de puissance 108 est formée à partir d'une couche de GaN 228 sur laquelle est disposée une couche 230 d'AlGaN dans laquelle sont réalisées les régions de canal, de source et de drain du transistor 108. Des électrodes 232, 234 et 236 forment respectivement les électrodes de source, de grille et de drain du transistor 108.

L'utilisation de tels composants est possible grâce à la structure du dispositif 100 qui forme autour des composants un packaging optimisé au niveau CEM permettant de limiter les inductances parasites de boucles (car de tels composants peuvent commuter plus rapidement que ceux réalisés en technologie semi-conducteur verticale), et également optimisé pour la thermique (la densité de puissance avec les composants à base de GaN est supérieure à celle équivalente en silicium car ces composants ont des plus petites dimensions à calibre en courant égal).

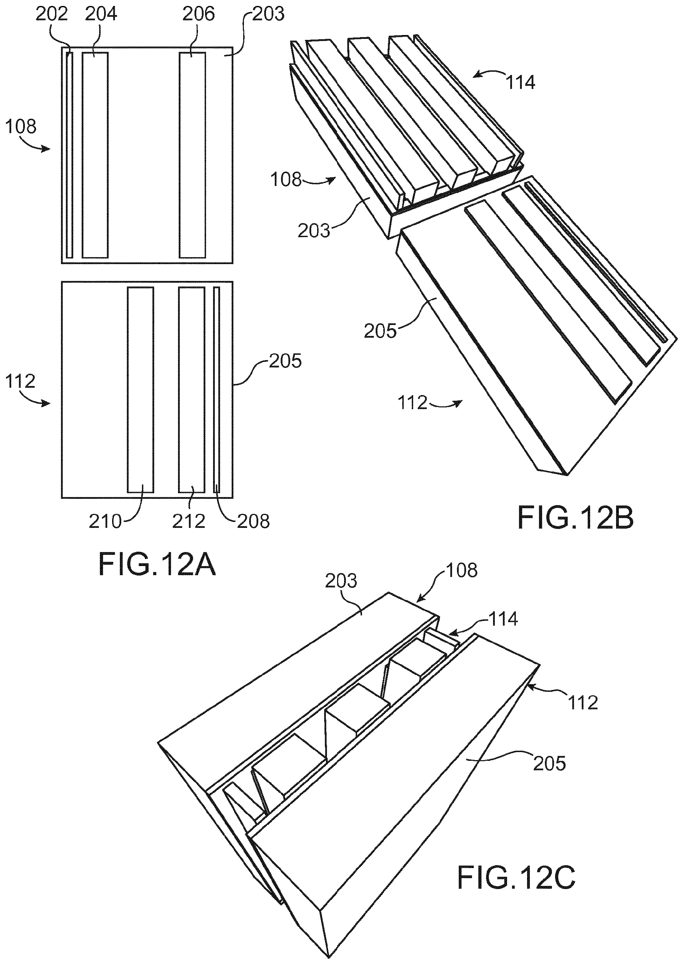

Les figures 12A - 12C représentent des étapes d'un assemblage de composants latéraux pour réalisation d'un dispositif électronique de puissance 100 comportant une cellule de commutation formée par deux transistors.

Comme représenté sur la figure 12A, un premier transistor 108 est réalisé à partir d'un premier substrat de silicium 203 et comporte, au niveau d'une face avant, une première métallisation 202 reliée à la grille du transistor 108, une deuxième métallisation 204 reliée au drain du transistor 108 et une troisième métallisation 206 reliée à la source du transistor 108. Un deuxième transistor 112 est réalisé à partir d'un deuxième substrat de silicium 205 et comporte, au niveau d'une face avant, une première métallisation 208 reliée à la grille du transistor 112, une deuxième métallisation 210 reliée à la source du transistor 112 et une troisième métallisation 212 reliée au drain du transistor 112.

L'élément de contact électrique 114 utilisé pour l'assemblage des deux transistors 108, 112 pour former la cellule de commutation comporte ici cinq portions distinctes : une première portion destinée à être en contact avec la métallisation 202, une deuxième portion destinée à être en contact avec la métallisation 204, une troisième portion destinée à être en contact avec la métallisation 208, une quatrième portion destinée à être en contact avec la métallisation 210, et une cinquième portion destinée à être en contact avec les métallisations 206 et 212 (ces deux métallisations étant réalisées telles qu'elles se trouvent l'une en regard de l'autre lors de l'assemblage des deux transistors 108, 112 à l'élément 114). Comme représenté sur la figure 12B, une première face principale de l'élément 114 est assemblée sur l'un des deux transistors 108, 112.

Une deuxième face principale de l'élément 114, opposée à sa première face principale, est assemblée sur l'autre des deux transistors 108, 112 (figure 12C). Ainsi, comme pour les dispositifs 100 précédemment décrits, tous les contacts des composants 108, 112 de la cellule de commutation se retrouvent sur l'une des tranches, ou faces latérales, de l'assemblage réalisé. Le point milieu de la cellule de commutation réalisée se retrouve sur la cinquième portion de l'élément 114 qui est reliée à la fois à la source du transistor 108 et au drain du transistor 112.

Ici, toutes les électrodes des premier et deuxième composants 108, 112 de la cellule de commutation sont reliées à l'élément de contact électrique 114 disposé entre les composants 108, 112.

Deux niveaux de métallisations disposés dans des couches diélectriques inter-métal (ILD) sont par exemple réalisés sur les zones actives de chacun des composants pour réaliser les électrodes de ces composants. Les métallisations 202-212 correspondent au deuxième niveau de métallisations. Ce deuxième niveau peut comporter des métallisations supplémentaires par rapport aux métallisations 202-212 afin que les portions de l'élément 114 soient toutes en contact avec des portions de métal au niveau des deux composants 108, 112. Ces métallisation supplémentaires ne sont par contre par reliées électriquement aux zones actives des composants 108, 112 et servent uniquement à obtenir un bon assemblage mécanique de l'empilement. Ainsi, les portions de l'élément 114 se trouvant contre la face avant d'un des transistors 108, 112 mais qui ne sont pas destinées à être reliées électriquement à ce transistor, sont en contact avec des métallisations qui sont isolées électriquement des autres niveaux de connexion du transistor par une couche diélectrique ILD. Ces portions ne sont pas reliées électriquement à la zone active du transistor. Cette configuration permet de bien répartir les contraintes mécaniques lors de l'assemblage du dispositif 100.

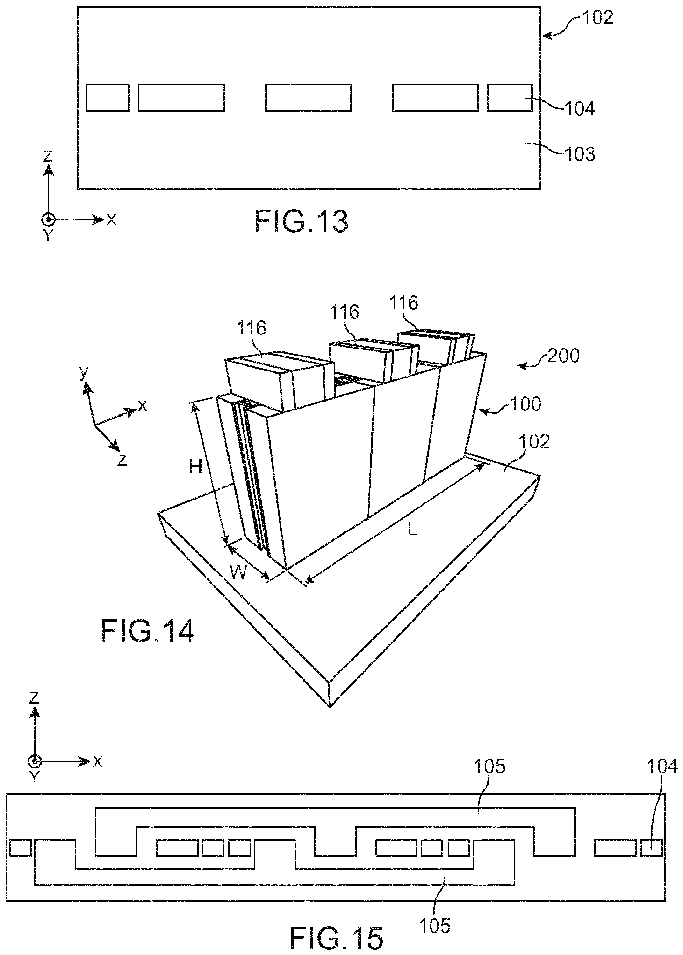

La figure 13 représente les métallisations 104 du support 102 destiné à recevoir un tel assemblage. Dans cette configuration, les métallisations 104 sont alignées les unes à côté des autres le long d'un axe (parallèle à l'axe X sur la figure 13). La largeur des métallisations (dimension parallèle à l'axe Z représenté sur la figure 13) est par exemple comprise entre environ 300 et 500 µm) et la longueur (dimension selon l'axe X) occupée par les métallisations 104 sur le support 102 est par exemple comprise entre environ 50 µm et 200 µm pour le plot de grille, et 400 µm et 1 mm pour le plot de source. La longueur totale du support 102 est par exemple égale à environ 3,3 mm.

La figure 14 représente schématiquement un convertisseur statique 200 réalisé à partir d'un dispositif électronique de puissance 100 comportant des composants de puissance latéraux tels que précédemment décrits. Ce convertisseur statique 200 correspond ici à un onduleur triphasé formé par un dispositif 100 comportant trois cellules de commutation, chaque cellule formant un bras du convertisseur. Chacun des bras du convertisseur 200 est couplé à un condensateur de découplage 116. La hauteur H (dimension selon l'axe Y) de l'empilement formant les cellules de commutation est par exemple comprise entre environ 3 mm et 5 mm et par exemple égale à environ 4,4 mm. La largeur W (dimension selon l'axe Z) de l'empilement est par exemple comprise entre environ 1 mm et 3 mm selon l'épaisseur du substrat sur lequel les composants sont réalisés, et par exemple égale à environ 2 mm. La longueur L (dimension selon l'axe X) de l'empilement est par exemple comprise entre environ 0,5 cm et 2 cm selon le calibre en courant des composants et par exemple égale à environ 1 cm.

La figure 15 représente les métallisations 104 du support 102 destiné à recevoir un tel assemblage des composants du convertisseur 200 précédemment décrit en liaison avec la figure 14. Ces métallisations 104 sont alignées selon l'axe X, comme pour l'exemple de la figure 13 précédemment décrit, du fait que dans l'empilement formant les trois cellules de commutation, toutes les électrodes des composants sont reliées à l'élément 114 disposé entre les composants 108, 112 des cellules. Des pistes métalliques 105 sont également présentes sur le support 102 pour relier entre elles les métallisations destinées à recevoir les potentiels d'alimentation électrique des cellules de commutation.

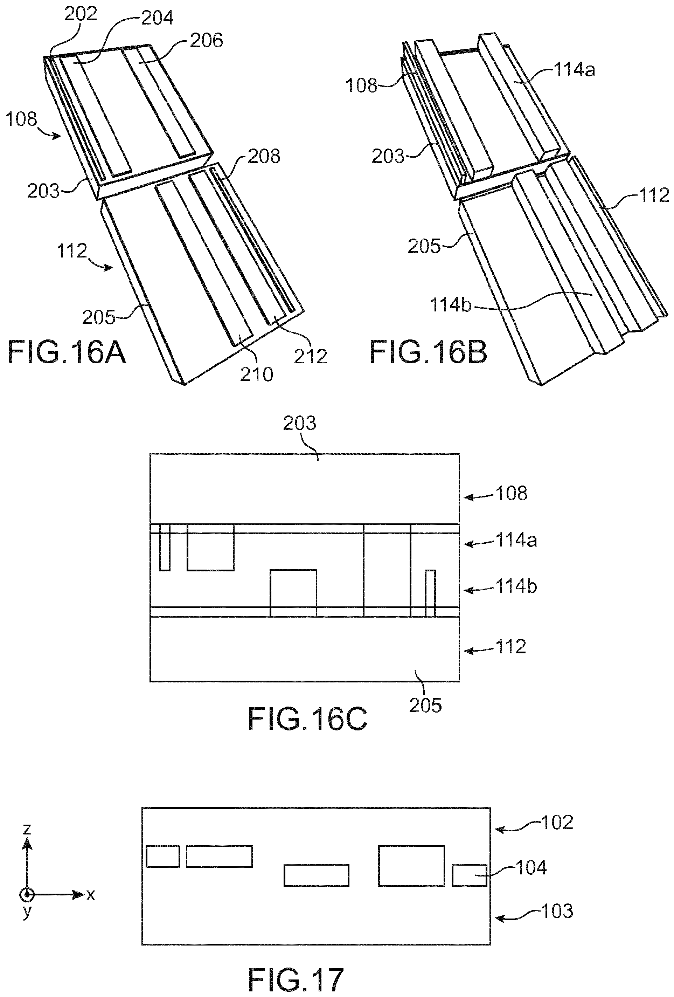

Les figures 16A - 16C représentent des étapes d'un assemblage de composants latéraux pour réalisation d'un dispositif électronique de puissance 100 comportant une cellule de commutation formée par deux transistors, selon une variante du procédé précédemment décrit en liaison avec les figures 12A - 12C.

Comme représenté sur la figure 16A, les transistors 108 et 112 sont tout d'abord réalisés à partir de deux substrats semi-conducteurs, de manière analogue à celle précédemment décrite en liaison avec la figure 12A.

Deux éléments de contact électrique 114a, 114b distincts sont ensuite réalisés, chacun sur l'un des deux composants 108, 112 (figure 16B). Chacun des éléments de contact électrique 114a, 114b comporte des portions reliées chacune à l'une des électrodes des composants 108, 112.

Les composants 108, 112 sont ensuite assemblés l'une à l'autre tels que les éléments 114a, 114b soient disposés l'un en regard de l'autre. La réunion des deux éléments 114a, 114b forme l'élément de contact électrique de la cellule de commutation. Dans l'exemple représenté sur la figure 16C (vue de la face latérale de l'empilement destinée à être en contact avec le support 102), l'une des portions de chacun des éléments 114a, 114b sont disposées l'une contre l'autre, ici pour former le point milieu de la cellule de commutation. Les autres portions des éléments 114a, 114b sont isolées du composant se trouvant en regard de celles-ci par un diélectrique, par exemple sous la forme d'un gel d'encapsulation (« underfill ») afin d'améliorer le maintien mécanique obtenu car la surface de contact entre les composants 108, 114 et l'élément 114 est plus faible que dans le cas du procédé précédemment décrit en liaison avec les figures 12A - 12C.

L'utilisation de deux éléments 114a, 114b distincts lors de la réalisation de l'assemblage a pour avantage d'éloigner les portions métalliques non communes aux deux composants vis-à-vis du composant non contacté par ces portions, ce qui améliore l'isolation électrique de ces portions vis-à-vis du composant auquel ces portions ne sont pas reliées électriquement.

La figure 17 représente les métallisations 104 du support 102 destiné à recevoir un tel assemblage. La disposition de ces métallisations 104 correspond à la disposition des portions métalliques des éléments 114a, 114b représentées sur la figure 16C.

Dans les différents modes et variantes de réalisation précédemment décrits, le dispositif 100 est réalisé en disposant les cellules de commutation les unes à côté des autres sur le support 102. Selon une variante de réalisation couverte par les revendications, e dispositif 100 est réalisé tel que plusieurs cellules de commutation se retrouvent superposées, ou empilées, sur le support 102. Les figures 18 à 20 représentent des éléments permettant la réalisation d'un dispositif 100, formant ici un convertisseur statique 200 correspondant à l'onduleur triphasé précédemment décrit en liaison avec la figure 11.

Comme représenté sur la figure 18, trois premiers composants électroniques de puissance 108.1, 108.2 et 108.3, correspondant à des transistors latéraux, par exemple de type HEMT, chacun destiné à faire partie d'une des trois cellules de commutation du convertisseur 200, sont réalisés à partir du premier substrat de silicium 203. Chacun des premiers transistors 108.1, 108.2 et 108.3 comporte, au niveau d'une face avant, une première métallisation 202.1, 202.2 et 202.3 reliée à la grille du premier transistor correspondant, une deuxième métallisation 204.1, 204.2 et 204.3 reliée au drain du premier transistor correspondant et une troisième métallisation 206.1, 206.2 et 206.3 reliée à la source du premier transistor correspondant. Trois deuxièmes composants électroniques de puissance 112.1, 112.2 et 112.3, correspondant à des transistors latéraux, par exemple de type HEMT, chacun destiné à faire partie d'une des trois cellules de commutation du convertisseur 200, sont réalisés à partir d'un deuxième substrat de silicium 205. Chacun des transistors 112.1, 112.2 et 112.3 comporte, au niveau d'une face avant, une première métallisation 208.1, 208.2 et 208.3 reliée à la grille du deuxième transistor correspondant, une deuxième métallisation 210.1, 210.2 et 210.3 reliée à la source ou au drain (selon le type des deuxièmes transistors) du deuxième transistor correspondant, et une troisième métallisation 212.1, 212.2 et 212.3 reliée au drain ou à la source (selon le type des deuxièmes transistors) du deuxième transistor correspondant. Les transistors 108 et 112 correspondent à des composants de puissance latéraux.

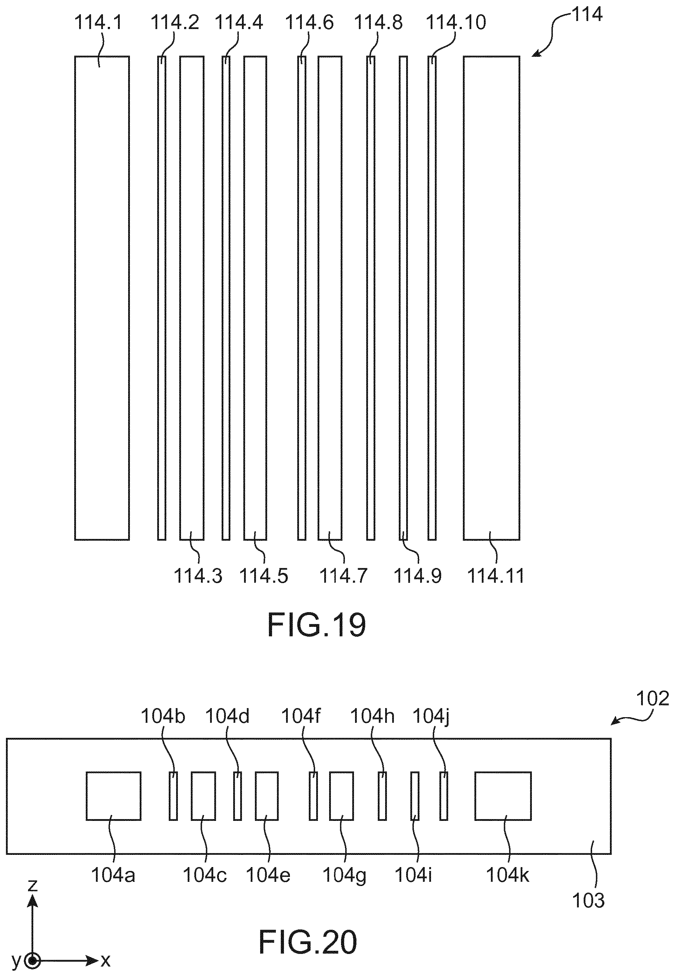

Comme représenté sur la figure 19, l'élément de contact électrique 114 utilisé pour l'assemblage des six transistors 108.1 - 108.3 et 112.1 - 112.3 pour former le convertisseur statique 200 comporte onze portions distinctes 114.1 à 114.11 dont :
- une première portion 114.1 destinée à être en contact avec les métallisations 204.1, 204.2 et 204.3 (ces trois métallisations étant alignées les unes avec les autres du fait qu'elles sont destinées à être en contact avec la première portion 114.1) ;
- une deuxième portion 114.2 destinée à être en contact avec la métallisation 202.1 ;
- une troisième portion 114.3 destinée à être en contact avec les métallisations 206.1 et 212.3 ;
- une quatrième portion 114.4 destinée à être en contact avec la métallisation 202.2 ;
- une cinquième portion 114.5 destinée à être en contact avec les métallisations 206.2 et 212.2 (ces deux métallisations étant réalisées telles qu'elles se trouvent l'une en regard de l'autre lors de l'assemblage des transistors 108 à l'élément 114) ;
- une sixième portion 114.6 destinée à être en contact avec la métallisation 202.3 ;
- une septième portion 114.7 destinée à être en contact avec les métallisations 206.3 et 212.1 ;
- une huitième portion 114.8 destinée à être en contact avec la métallisation 208.3 ;
- une neuvième portion 114.9 destinée à être en contact avec la métallisation 208.2 ;
- une dixième portion 114.10 destinée à être en contact avec la métallisation 208.1 ;
- une onzième portion 114.11 destinée à être en contact avec les métallisations 210.1, 210.2 et 210.3 (ces trois métallisations étant alignées les unes avec les autres du fait qu'elles sont destinées à être en contact avec la onzième portion 114.11).

Une première face principale de l'élément 114 est assemblée sur les premiers transistors 108.1 - 108.3. Une deuxième face principale de l'élément 114, opposée à sa première face principale, est assemblée sur les deuxièmes transistors 112.1 - 112.3. Les références 207.1 et 207.2 représentées sur la figure 18 désignent le côté de chacun des substrats 203, 205 destiné à être disposé du côté du support 102. Tous les contacts du convertisseur statique 200 se retrouvent sur l'une des tranches, appelée première face latérale, de l'assemblage réalisé, du fait que toutes les électrodes des premier et deuxième composants 108, 112 du convertisseur statique 200 sont reliées à l'élément de contact électrique 114 disposé entre les composants 108, 112. La première face latérale de l'empilement ainsi obtenue est reportée et assemblée sur onze métallisations 104a à 104k du support 102 représenté sur la figure 20 via les portions 114.1 - 114.11. Dans cette configuration, la longueur (dimension selon l'axe X) du support 102 est par exemple de l'ordre de 10 mm et sa largeur (dimension selon l'axe Z) est par exemple comprise entre environ 300 µm et 500 µm.

Un condensateur de découplage peut ensuite être disposé au niveau d'un deuxième côté, ou deuxième face latérale, de l'empilement, c'est-à-dire au niveau de deuxièmes faces latérales des couches 106, 110, opposées aux premières faces latérales disposées du côté du support 102. Les métallisations 104a et 104k, qui correspondent à celles sur lesquelles les potentiels électriques d'alimentation continue sont destinés à être appliqués, sont disposées aux extrémités du support 102 afin de faciliter l'intégration du condensateur de découplage.

Les autres détails et possibilités de réalisation précédemment décrits s'applique également à cette variante de réalisation.

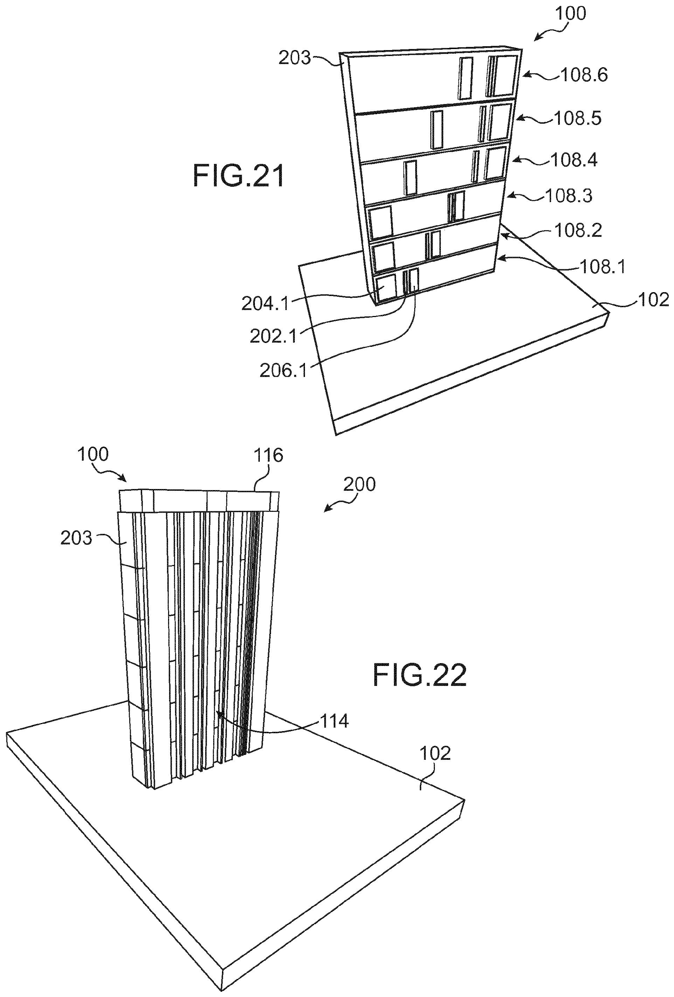

Selon une autre variante de réalisation couverte par les revendications, le dispositif 100 peut être réalisé tel que tous les composants du dispositif 100 soient réalisés sur un même substrat disposé verticalement sur le support 102. Les figures 21 et 22 sont décrites ci-dessous en lien avec la réalisation du convertisseur statique 200 de la figure 11 selon cette autre variante de réalisation.

Six transistors 108.1 à 108.6, à partir desquels les trois cellules de commutation du convertisseur 200 seront réalisées, sont réalisés sur le substrat 203. Les trois transistors 108.1 et 108.3 sont similaires aux transistors 108.1 à 108.3 précédemment décrits en lien avec la figure 18, et les trois transistors 108.4 à 108.6 sont similaires aux transistors 112.1 à 112.3 précédemment décrits, excepté que les trois transistors 108.4 à 108.6 sont réalisés à partir du même substrat que les transistors 108.1 à 108.3. Les métallisations 202, 204 et 206 des transistors 108 sont disposées au niveau d'une même face à laquelle l'élément de contact électrique 114 est solidarisé, comme représenté sur la figure 22. Sur la figure 21, seules les métallisations 202.1, 204.1 et 206.1 sont référencées pour des raisons de facilité de lecture de cette figure. Sur la figure 21, le substrat 203 est représenté en position verticale sur le support 102 afin de faciliter la compréhension de la disposition des transistors 108.1 - 108.6 sur le substrat 203 lorsque celui-ci est positionné sur le support 102. Toutefois, l'élément de contact électrique 114 est solidarisé, au niveau d'une de ses deux faces principales, aux métallisations des transistors 108 préalablement au montage de l'empilement ainsi obtenu sur le support 102.

Cette variante décrite en liaison avec les figures 21 et 22 est avantageuse lorsque les transistors 108 sont des transistors de puissance latéraux par exemple réalisés en technologie GaN sur silicium. Selon cette technologie, le substrat 203 correspond à un substrat de silicium d'épaisseur par exemple comprise entre environ 725 µm et 1 mm. Les zones actives des transistors 108 sont réalisées dans un empilement AlGaN / GaN disposé sur le substrat 203 et dont l'épaisseur est généralement inférieure à environ 10 µm. Du fait que de tels composants de puissance latéraux ont une seule face active (du côté de l'empilement AlGaN / GaN), la totalité des courants circule dans cette zone très fine. La densité de puissance à évacuer est donc importante. Le substrat de silicium 203, permettant de rendre compatible la réalisation de tels transistors avec les infrastructures standards de production de la microélectronique, est toutefois problématique pour réaliser le refroidissement des transistors 108 depuis leur face arrière du fait que ce substrat 203 est épais et que la conductivité du silicium est faible (de l'ordre de 148 W.m⁻¹.K⁻¹) par rapport à celles d'autres matériaux semi-conducteurs utilisés en électronique de puissance comme le carbure de silicium (de l'ordre de 500 W.m⁻¹.K⁻¹). A partir du dispositif 100 tel que représenté sur la figure 22, la face avant des transistors 108 est librement accessible via l'élément de contact électrique 114. Il est donc possible de réaliser un refroidissement du dispositif 100 depuis la face arrière du substrat 203 mais également depuis la face avant des transistors à travers l'élément de contact électrique 114.

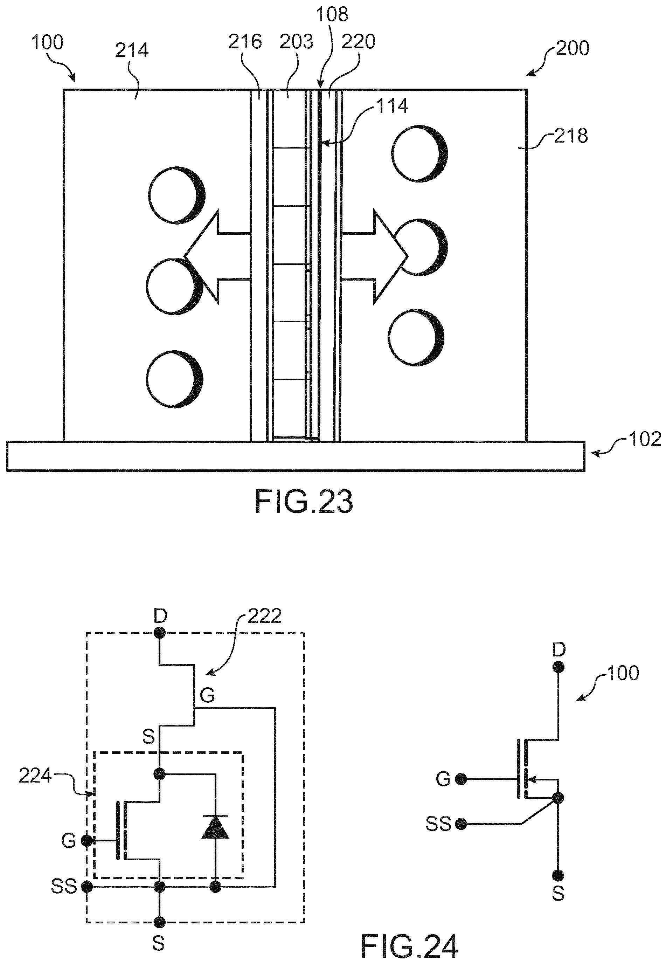

La figure 23 représente le dispositif 100 qui comprend un premier dissipateur thermique 214 disposé contre une face arrière du premier substrat 203 (par l'intermédiaire d'une couche diélectrique 216) et un deuxième dissipateur thermique 218 disposé contre l'élément de contact électrique 114 (par l'intermédiaire d'une couche diélectrique 220). Dans cette configuration, le deuxième dissipateur thermique 218 assure la majeure partie du refroidissement du dispositif 100. Dans l'exemple de réalisation décrit avec la figure 23, les dissipateurs thermiques 214, 218 sont de type plaques à eau. L'ajout d'un condensateur de découplage sur un tel dispositif 100 est possible.

Dans tous les modes et variantes de réalisation précédemment décrits, il est avantageux de réaliser chaque cellule de commutation avec des interrupteurs complémentaires, par exemple avec un premier transistor de type à appauvrissement ou « Normally-On » (c'est-à-dire passant en l'absence de tension de polarisation appliquée sur sa grille) et un deuxième transistor de type à enrichissement ou « Normally-Off » (bloqué en l'absence de tension de polarisation appliquée sur sa grille). Dans une telle configuration, la commande de la cellule de commutation peut être réalisée à partir d'une seule portion de l'élément de contact électrique 114 reliée aux grilles de ces deux transistors complémentaires.

La configuration du dispositif 100 réalisé sous la forme d'un empilement agencé verticalement sur le support 102 est également avantageuse pour combiner un transistor de puissance latéral de type « Normally-On », par exemple réalisé en technologie HEMT AlGaN / GaN, avec un transistor MOS latéral de type « Normally-Off » selon un montage cascode. Dans un tel montage schématisé sur la figure 24, un premier transistor de puissance HEMT « Normally-On » 222 à base de GaN comporte sa source reliée au drain d'un deuxième transistor NMOS « Normally-Off » 224 (qui comporte une diode antiparallèle reliée entre sa source et son drain). Le dispositif 100 formé avec un tel montage, correspondant à un transistor de puissance, est également représenté symboliquement sur la figure 24. Cette association des deux transistors 222, 224 est sensible aux inductances de maille entre les composants, particulièrement au niveau du point commun de ces deux transistors 222, 224 (point de liaison entre la source du premier transistor 222 et le drain du deuxième transistor 224). De plus, pour garantir une bonne commande du transistor 222, l'inductance de source du transistor 224 doit être la plus faible possible pour ne pas perturber l'ordre de commutation du circuit de pilotage (driver) qui commande ce dispositif 100. La réalisation du dispositif 100 sous la forme d'un empilement agencé verticalement sur le support 102 répond à ces problématiques.

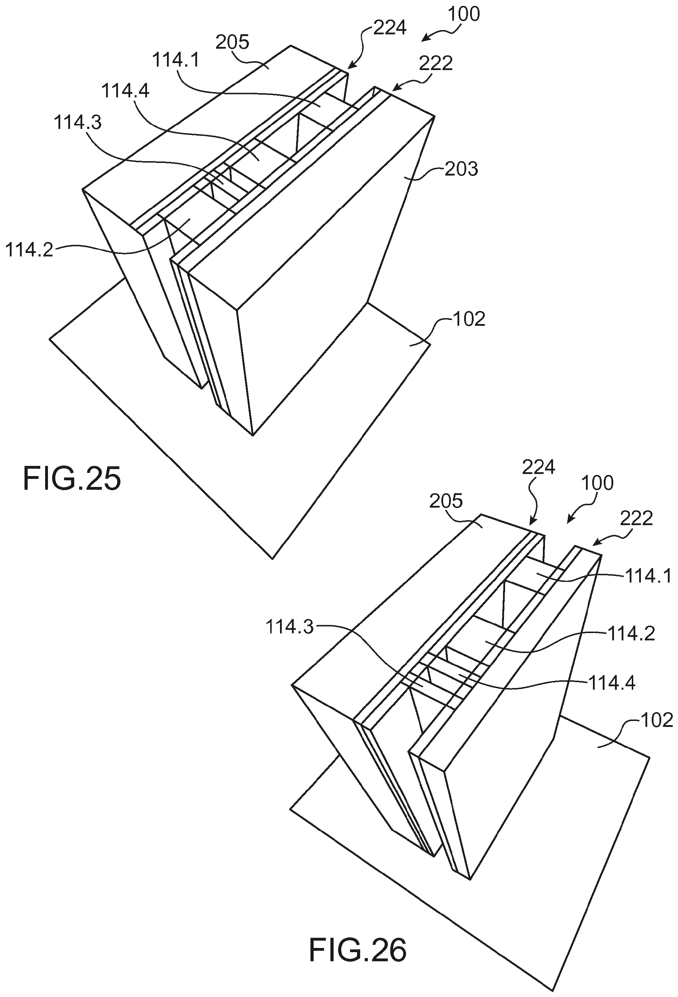

La figure 25 représente le dispositif 100 réalisé selon le montage décrit sur la figure 24, c'est-à-dire comportant le premier transistor 222 (correspondant au premier composant électronique de puissance 108) réalisé sur un premier substrat 203, le deuxième transistor 224 réalisé sur un deuxième substrat 205 par exemple de type SOI, les deux transistors étant solidarisés et reliés électriquement l'un à l'autre par l'élément de contact électrique 114 du fait que ces deux transistors comportent chacun leurs électrodes disposées sur une même face, l'empilement formé étant agencé verticalement sur le support 102. L'élément de contact électrique 114 comporte une première portion 114.1 reliée au drain du premier transistor 222, une deuxième portion 114.2 reliée à la source du premier transistor 222, une troisième portion 114.3 reliée à la grille du deuxième transistor 224, et une quatrième portion 114.4 reliée à une connexion, ou électrode, Kelvin de la source du dispositif 100, référencée SS sur la figure 24, au niveau de la source du deuxième transistor 224. Lorsque plusieurs transistors MOS ou CMOS sont réalisés sur le deuxième substrat 205, comme par exemple lors de la réalisation d'un convertisseur statique tel que précédemment décrit, ces transistors sont isolés les uns par rapport aux autres.

En variante, le dispositif 100 peut correspondre à l'assemblage d'un premier transistor de puissance 222 relié à une première face principale de l'élément de contact électrique 114, avec un circuit de commande réalisé en technologie CMOS avec des composants latéraux et relié à une deuxième face principale de l'élément de contact électrique 114. Ce circuit de commande permet par exemple de convertir une commande en courants faibles en des signaux de commande de puissance adaptés aux transistors de puissance. Un tel dispositif 100 est représenté sur la figure 26. Dans cet exemple de réalisation, le premier substrat 203 est aminci afin que seule la couche ou l'empilement de couches à base de GaN formant la zone active du premier transistor 222 soit conservée et disposée verticalement sur le support 102 (ce qui facilite le refroidissement du premier transistor 222). Le circuit de commande, ici réalisé en technologie SOI, est référencé 226 sur la figure 26. L'élément de contact électrique 114 comporte les mêmes portions que celles précédemment décrites en liaison avec la figure 25. Un tel dispositif 100 peut être réalisé en mettant en œuvre les étapes suivantes :
- réalisation du premier transistor de puissance 222 sur le premier substrat 203 de type GaN sur silicium, au cours de laquelle est réalisée une isolation des différents composants de puissance formés sur le premier substrat 203 pour maintenir la tenue en tension des composants monolithiques, et la réalisation d'un niveau métallique adapté pour former des plots métalliques adaptés pour être reliés à l'élément de contact électrique 114 ;
- réalisation du circuit de commande 226 en technologie SOI haute tension sur le deuxième substrat 205, au cours de laquelle le dernier niveau métallique formé est compatible avec l'élément de contact électrique 114, et dont les composants sont formés en îlots ;
- report des substrats 203, 205 sur l'élément de contact électrique 114 ;
- retrait total du support de silicium du premier substrat 203, via la mise en œuvre d'un rabotage mécanique et d'une attaque chimique ;
- découpe de l'empilement formé au niveau des zones d'isolation des composants de puissance ;
- report et assemblage sur le support 102.

La réalisation d'un composant de puissance 222 et de son circuit de commande 226 sous la forme d'un tel empilement agencé verticalement sur le support 102 permet d'obtenir une disposition du circuit de commande 226 au plus près du composant de puissance 222. Cet agencement permet également de supprimer la couche de silicium servant de support mécanique lors de la réalisation de composants de puissance de type GaN. Or, en présence de cette couche de silicium, les composants de puissance présentent une moins bonne tenue en tension. La suppression de cette couche de silicium permet donc d'augmenter cette tenue en tension des composants de puissance, et permet d'éviter un claquage vertical prématuré qui serait dû à la présence de cette couche de silicium.

Dans cette configuration, il est également possible qu'une portion supplémentaire 114.5 de l'élément de contact électrique relie électriquement au moins une électrode supplémentaire, appelée par exemple « sense », du circuit de commande 226 au composant de puissance 222 afin de transmettre des informations depuis le composant de puissance 222 au circuit de commande 226, comme représenté sur la figure 27. Une telle électrode supplémentaire sert par exemple à la mesure de la température du composant de puissance 222 en instantanée. La température du composant de puissance 222 est un exemple d'information permettant la commande d'un transistor de puissance. En variante, cette électrode peut également servir à transmettre des informations relatives au courant passant dans le transistor de puissance ou une information relative au vieillissement du transistor. Cette électrode permet au circuit de commande 226 de réagir instantanément sur la commande du composant de puissance 222 puis de relayer l'information au niveau supérieur du pilotage du composant de puissance 222.

## Revendications

1. Dispositif électronique de puissance (100) comportant :
- plusieurs premiers composants électroniques de puissance (108, 222) de type latéral réalisés sur un même substrat en silicium et dont toutes les électrodes de chacun des premiers composants électroniques de puissance (108, 222) sont disposées au niveau d'une première face principale de chacun des premiers composants électroniques de puissance (108, 222) ;
- au moins un élément de contact électrique (114) dont une première face principale est disposée contre la première face principale de chacun des premiers composants électroniques de puissance (108, 222) et comprenant plusieurs portions (114.1 - 114.11) distinctes électriquement conductrices auxquelles les électrodes de chacun des premiers composants électroniques de puissance (108, 222) sont reliées électriquement ;
dans lequel au moins les premiers composants électroniques de puissance (108, 222) et l'élément de contact électrique (114) forment ensemble un empilement tel qu'une première face latérale de chacune des portions (114.1 - 114.11) de l'élément de contact électrique (114), sensiblement perpendiculaire à la première face principale de l'élément de contact électrique (114), soit disposée contre au moins une métallisation (104) d'un support (102) formant au moins un contact électrique de chacun des premiers composants électroniques de puissance (108, 222), et les premiers composants électroniques de puissance (108, 222) sont disposés les uns au-dessus des autres selon une direction sensiblement perpendiculaire aux premières faces latérales des portions de l'élément de contact électrique (114).

2. Dispositif électronique de puissance (100) selon la revendication 1, dans lequel les premiers composants électroniques de puissance (108, 222) comportent un premier substrat semi-conducteur (203) formant une deuxième face principale, opposée à la première face principale, de chacun des premiers composants électroniques de puissance (108, 222).

3. Dispositif électronique de puissance (100) selon l'une des revendications précédentes, dans lequel les premiers composants électroniques de puissance (108, 222) forment ensemble plusieurs cellules de commutation, chaque cellule de commutation étant formée par deux premiers composants électroniques de puissance (108, 222) reliés électriquement ensemble par au moins une des portions de l'élément de contact électrique (114).

4. Dispositif électronique de puissance (100) selon l'une des revendications précédentes, comportant en outre au moins un dissipateur thermique (218) disposé contre une deuxième face principale, opposée à la première face principale, de l'élément de contact électrique (114).

5. Dispositif électronique de puissance (100) selon l'une des revendications 1 à 4, comportant plusieurs deuxièmes composants électroniques de puissance (112) de type latéral réalisés sur un autre même substrat en silicium, tels que toutes les électrodes de chacun des deuxièmes composants électroniques de puissance (112) soient disposées au niveau d'une première face principale de chacun des deuxièmes composants électroniques de puissance (112) et reliées électriquement aux portions de l'élément de contact électrique (114) au niveau de la deuxième face principale de l'élément de contact électrique (114), et tels que les deuxièmes composants électroniques de puissance (112) sont disposés les uns au-dessus des autres selon une direction sensiblement perpendiculaire aux premières faces latérales des portions de l'élément de contact électrique (114), chacun des deuxièmes composants électroniques de puissance (112) faisant partie de l'empilement et formant, avec l'un des premiers composants électroniques de puissance (108, 222), une cellule de commutation.

6. Dispositif électronique de puissance (100) selon l'une des revendications précédentes, comportant en outre, lorsque les premiers et/ou deuxièmes composants électroniques de puissance (108, 112, 222) forment au moins une cellule de commutation, au moins :
- un condensateur de découplage (116) relié à la cellule de commutation tel que la cellule de commutation soit disposée entre le support (102) et le condensateur de découplage (116), et/ou
- un circuit de commande (118) apte à commander une commutation de la cellule de commutation et disposé sur une face arrière du support (102) qui est opposée à une face avant du support (102) au niveau de laquelle se trouvent les métallisations (104), et/ou
- des dissipateurs thermiques (128, 130) disposés contre des deuxièmes faces principales des premier et deuxième substrats (106, 110, 203, 205) opposées aux premières faces principales.

7. Dispositif électronique de puissance (100) selon la revendication 6, dans lequel les dissipateurs thermiques (128, 130) font partie d'un boîtier reposant sur le support (102) et dans lequel ledit empilement est disposé, une paroi de fond (150) du boîtier formant un dissipateur thermique supplémentaire.

8. Convertisseur statique (200) comportant au moins un dispositif électronique de puissance (100) selon l'une des revendications précédentes formant au moins une cellule de commutation.

9. Procédé de réalisation d'un dispositif électronique de puissance (100), comportant au moins la mise en œuvre des étapes suivantes :
- réalisation, sur un même substrat de silicium, de plusieurs premiers composants électroniques de puissance (108, 222) de type latéral et dont toutes les électrodes de chacun des premiers composants électroniques de puissance (108, 122) sont disposées au niveau d'une première face principale de chacun des premiers composants électroniques de puissance (108, 222) ;
- solidarisation de chacun des premiers composants électroniques de puissance (108, 222) à au moins un élément de contact électrique (114) tel qu'une première face principale de l'élément de contact électrique (114) soit disposée contre la première face principale de chacun des premiers composants électroniques de puissance (108, 222), reliant électriquement plusieurs portions (114.1 - 114.11) distinctes de l'élément de contact électrique (114) aux électrodes de chacun des premiers composants électroniques de puissance (108, 222), les premiers composants électroniques de puissance (108, 222) et l'élément de contact électrique (114) formant ensemble un empilement ;
- solidarisation d'au moins une première face latérale de chacune des portions (114.1 - 114.11) de l'élément de contact électrique (114), sensiblement perpendiculaire à la première face principale de l'élément de contact électrique (114), contre au moins une métallisation (104) d'un support (102) formant au moins un contact électrique de chacun des premiers composants électroniques de puissance (108, 222) ;
et dans lequel les premiers composants électroniques de puissance (108, 222) sont disposés les uns au-dessus des autres selon une direction sensiblement perpendiculaire aux premières faces latérales des portions de l'élément de contact électrique (114).

10. Procédé selon la revendication 9, comportant en outre, avant la solidarisation de l'élément de contact électrique (114) au support (102), les étapes de :
- réalisation, sur un même autre substrat de silicium, de plusieurs deuxièmes composants électroniques de puissance (112) de type latéral et dont toutes les électrodes sont disposées au niveau d'une première face principale du deuxième composant électronique de puissance (112),
- solidarisation de chacun des deuxièmes composants électroniques de puissance (112) à une deuxième face principale, opposée à la première face principale, de l'élément de contact électrique (114), telle que la deuxième face principale de l'élément de contact électrique (114) soit disposée contre la première face principale de chacun des deuxièmes composants électroniques de puissance (112) et reliant électriquement les électrodes du deuxième composant électronique de puissance (112) aux portions (114.1 - 114.11) de l'élément de contact électrique (114), et telle que les deuxièmes composants électroniques de puissance (112) sont disposés les uns au-dessus des autres selon une direction sensiblement perpendiculaire aux premières faces latérales des portions de l'élément de contact électrique (114), chacun des deuxièmes composants électroniques de puissance (112) faisant partie de l'empilement et formant, avec l'un des premiers composants électroniques de puissance (108, 222), une cellule de commutation.

11. Procédé selon l'une des revendications 9 et 10, comportant en outre, lorsque les premiers et/ou deuxièmes composants électroniques de puissance (108, 112, 222) forment au moins une cellule de commutation :
- l'assemblage d'au moins un condensateur de découplage (116) sur une face latérale de l'empilement, relié électriquement à la cellule de commutation tel que la cellule de commutation soit disposée entre le support (102) et le condensateur de découplage (116), et/ou
- l'assemblage d'au moins un circuit de commande (118), apte à commander une commutation de la cellule de commutation, sur une face arrière du support (102) opposée à une face avant au niveau de laquelle se trouvent les métallisations (104), et/ou
- l'assemblage de dissipateurs thermiques (128, 130) contre des deuxièmes faces principales, opposées aux premières faces principales, des premier et deuxième substrats (106, 110, 203, 205).

12. Procédé selon la revendication 11, dans lequel les dissipateurs thermiques (128, 130) font partie d'un boîtier reposant sur le support (102) et dans lequel ledit empilement est disposé, une paroi de fond (150) du boîtier formant un dissipateur thermique supplémentaire.

13. Procédé de réalisation d'un convertisseur statique (200), comportant la mise en œuvre d'un procédé de réalisation d'un dispositif électronique de puissance (100) selon l'une des revendications 9 à 12 formant au moins une cellule de commutation.

## Patentansprüche

1. Leistungselektronikvorrichtung (100), umfassend:
- mehrere erste Leistungselektronikkomponenten (108, 222) des Seitentyps, die auf demselben Siliziumsubstrat ausgeführt sind und deren alle Elektroden jeder der ersten Leistungselektronikkomponenten (108, 222) auf einer ersten Hauptfläche jeder der ersten Leistungselektronikkomponenten (108, 222) angeordnet sind;
- mindestens ein elektrisches Kontaktelement (114), dessen erste Hauptfläche gegen die erste Hauptfläche jeder der ersten Leistungselektronikkomponenten (108, 222) angeordnet ist und das mehrere getrennte elektrisch leitende Abschnitte (114.1 - 114.11) umfasst, mit denen die Elektroden jeder der ersten Leistungselektronikkomponenten (108, 222) elektrisch verbunden sind;
wobei mindestens die ersten Leistungselektronikkomponenten (108, 222) und das elektrische Kontaktelement (114) zusammen einen Stapel bilden, so dass eine erste Seitenfläche jedes der Abschnitte (114.1 - 114.11) des elektrischen Kontaktelements (114), im Wesentlichen senkrecht zur ersten Hauptfläche des elektrischen Kontaktelements (114), gegen mindestens eine Metallisierung (104) eines Trägers (102) angeordnet ist mindestens einen elektrischen Kontakt jeder der ersten Leistungselektronikkomponenten (108, 222) bildet, und die ersten Leistungselektronikkomponenten (108, 222) in einer Richtung im Wesentlichen senkrecht zu den ersten Seitenflächen der Abschnitte des elektrischen Kontaktelements (114) übereinander angeordnet sind.

2. Leistungselektronikvorrichtung (100) nach Anspruch 1, wobei die ersten Leistungselektronikkomponenten (108, 222) ein erstes Halbleitersubstrat (203) aufweisen, das eine zweite Hauptfläche, gegenüber der ersten Hauptfläche, jeder der ersten Leistungselektronikkomponenten (108, 222) bildet.

3. Leistungselektronikvorrichtung (100) nach einem der vorhergehenden Ansprüche, wobei die ersten Leistungselektronikkomponenten (108, 222) zusammen mehrere Schaltzellen bilden, wobei jede Schaltzelle aus zwei ersten Leistungselektronikkomponenten (108, 222) besteht, die durch mindestens einen der Abschnitte des elektrischen Kontaktelements (114) elektrisch miteinander verbunden sind.

4. Leistungselektronikvorrichtung (100) nach einem der vorhergehenden Ansprüche, ferner umfassend mindestens einen Kühlkörper (218), der an einer zweiten Hauptfläche, gegenüber der ersten Hauptfläche, des elektrischen Kontaktelements (114) angeordnet ist.

5. Leistungselektronikvorrichtung (100) nach einem der Ansprüche 1 bis 4, umfassend mehrere zweite Leistungselektronikkomponenten (112) des Seitentyps, die auf einem anderen gleichen Siliziumsubstrat ausgeführt sind, so dass alle Elektroden jeder der zweiten Leistungselektronikkomponenten (112) an einer ersten Hauptfläche jeder der zweiten Leistungselektronikkomponenten (112) angeordnet sind und elektrisch mit den Abschnitten des elektrischen Kontaktelements (114) an der zweiten Hauptfläche des elektrischen Kontaktelements (114) verbunden sind, und so, dass die zweiten Leistungselektronikkomponenten (112) in einer Richtung im Wesentlichen senkrecht zu den ersten Seitenflächen der Abschnitte des elektrischen Kontaktelements (114) übereinander angeordnet sind, wobei jede der zweiten Leistungselektronikkomponenten (112) Teil des Stapels sind und zusammen mit einer der ersten Leistungselektronikkomponenten (108, 222) eine Schaltzelle bilden.

6. Leistungselektronikvorrichtung (100) nach einem der vorhergehenden Ansprüche, ferner umfassend, wenn die ersten und/oder zweiten Leistungselektronikkomponenten (108, 112, 222) mindestens eine Schaltzelle bilden, mindestens:
- einen Entkopplungskondensator (116), der mit der Schaltzelle verbunden ist, so dass die Schaltzelle zwischen dem Träger (102) und dem Entkopplungskondensator (116) angeordnet ist, und/oder
- einen Steuerkreis (118), der in der Lage ist, eine Schaltung der Schaltzelle zu steuern und an einer Rückseite des Trägers (102) angeordnet ist, die einer Vorderseite des Trägers (102) gegenübersteht, an der sich die Metallisierungen (104) befinden, und/oder
- Kühlkörper (128, 130), die gegen zweite Hauptflächen der ersten und zweiten Substrate (106, 110, 203, 205) angeordnet sind, die den ersten Hauptflächen gegenüberliegen.

7. Leistungselektronikvorrichtung (100) nach Anspruch 6, wobei die Kühlkörper (128, 130) Teil eines Gehäuses sind, das auf dem Träger (102) aufliegt, und wobei der Stapel angeordnet ist, wobei eine Bodenwand (150) des Gehäuses einen zusätzlichen Kühlkörper bildet.

8. Statischer Wandler (200) mit mindestens einer Leistungselektronikvorrichtung (100) nach einem der vorhergehenden Ansprüche, die mindestens eine Schaltzelle bildet.

9. Verfahren zur Herstellung einer Leistungselektronikvorrichtung (100), das mindestens die Durchführung folgender Schritte umfasst:
- Ausführen mehrerer erster seitlicher Leistungselektronikkomponenten (108, 222) auf ein und demselben Siliziumsubstrat, wobei alle Elektroden jeder der ersten Leistungselektronikkomponenten (108, 122) an einer ersten Hauptfläche jeder der ersten Leistungselektronikkomponenten (108, 222) angeordnet sind;
- Verbinden jeder der ersten Leistungselektronikkomponenten (108, 222) mit mindestens einem elektrischen Kontaktelement (114), so dass eine erste Hauptfläche des elektrischen Kontaktelements (114) gegen die erste Hauptfläche jeder der ersten Leistungselektronikkomponenten (108, 222) angeordnet ist, wobei mehrere getrennte Abschnitte (114.1 - 114.11) des elektrischen Kontaktelements (114) mit den Elektroden jeder der ersten Leistungselektronikkomponenten (108, 222) elektrisch verbunden werden, wobei die ersten Leistungselektronikkomponenten (108, 222) und das elektrische Kontaktelement (114) zusammen einen Stapel bilden;
- Verbinden von mindestens einer ersten Seitenfläche jedes der Abschnitte (114.1 - 114.11) des elektrischen Kontaktelements (114), im Wesentlichen senkrecht zur ersten Hauptfläche des elektrischen Kontaktelements (114), gegen mindestens eine Metallisierung (104) eines Trägers (102), der mindestens einen elektrischen Kontakt jedes der ersten Leistungselektronikkomponenten (108, 222) bildet;
und wobei die ersten Leistungselektronikkomponenten (108, 222) in einer Richtung im Wesentlichen senkrecht zu den ersten Seitenflächen der Abschnitte des elektrischen Kontaktelements (114) übereinander angeordnet sind.

10. Verfahren nach Anspruch 9, ferner umfassend, vor dem Verbinden des elektrischen Kontaktelements (114) mit dem Träger (102), folgende Schritte:
- Ausführen mehrerer zweiter Leistungselektronikkomponenten (112) des Seitentyps auf demselben anderen Siliziumsubstrat, deren alle Elektroden auf einer ersten Hauptfläche der zweiten Leistungselektronikkomponente (112) angeordnet sind,
- Verbinden jeder der zweiten Leistungselektronikkomponenten (112) mit einer zweiten Hauptfläche, die der ersten Hauptfläche des elektrischen Kontaktelements (114) gegenübersteht, so dass die zweite Hauptfläche des elektrischen Kontaktelements (114) gegen die erste Hauptfläche jeder der zweiten Leistungselektronikkomponenten (112) angeordnet ist und die Elektroden der zweiten Leistungselektronikkomponenten (112) elektrisch mit den Abschnitten (114.1 - 114.11) des elektrischen Kontaktelements (114) verbindet, und so, dass die zweiten Leistungselektronikkomponenten (112) in einer Richtung im Wesentlichen senkrecht zu den ersten Seitenflächen der Abschnitte des elektrischen Kontaktelements (114) übereinander angeordnet sind, wobei jede der zweiten Leistungselektronikkomponenten (112) Teil des Stapels ist und mit einer der ersten Leistungselektronikkomponenten (108, 222) eine Schaltzelle bildet.

11. Verfahren nach einem der Ansprüche 9 und 10, ferner umfassend, wenn die ersten und/oder zweiten Leistungselektronikkomponenten (108, 112, 222) mindestens eine Schaltzelle bilden:
- Zusammenbauen mindestens eines Entkopplungskondensators (116) an einer Seitenfläche des Stapels, der elektrisch mit der Schaltzelle verbunden ist, so dass die Schaltzelle zwischen dem Träger (102) und dem Entkopplungskondensator (116) angeordnet ist, und/oder
- Zusammenbauen mindestens eines Steuerkreises (118), der in der Lage ist, eine Schaltung der Schaltzelle zu steuern, auf einer Rückseite des Trägers (102) gegenüber einer Vorderseite, an der sich die Metallisierungen (104) befinden, und/oder
- Zusammenbauen von Kühlkörpern (128, 130) gegen zweite, den ersten Hauptflächen gegenüberliegende Hauptflächen des ersten und zweiten Substrats (106, 110, 203, 205).

12. Verfahren nach Anspruch 11, wobei die Kühlkörper (128, 130) Teil eines Gehäuses sind, das auf dem Träger (102) aufliegt, und wobei der Stapel angeordnet ist, wobei eine Bodenwand (150) des Gehäuses einen zusätzlichen Kühlkörper bildet.

13. Verfahren zur Herstellung eines statischen Wandlers (200), umfassend die Durchführung eines Verfahrens zur Herstellung einer Leistungselektronikvorrichtung (100) nach einem der Ansprüche 9 bis 12, die mindestens eine Schaltzelle bildet.

## Claims

1. Electronic power device (100) comprising:
- several first electronic power components (108, 222) of lateral type arranged on a same silicon substrate with all the electrodes of each the first electronic power components (108, 222) are arranged at a first main face of each of the first electronic power components (108, 222);
- at least one electric contact element (114) in which a first main face is arranged against the first main face of each of the first electronic power components (108, 222) and which comprises several separate electrically conducting portions (114.1 - 114.11) to which the electrodes of each of the first electronic power components (108, 222) are electrically connected;
in which at least the first electronic power components (108, 222) and the electric contact element (114) together form a stack such that a first lateral face of each of the portions (114.1 - 114.11) of the electric contact element (114), substantially perpendicular to the first main face of the electric contact element (114), is arranged against at least one metallization (104) of a support (102) forming at least one electric contact of each of the first electronic power components (108, 222), and the first electronic power components (108, 222) are arranged one above the other along a direction substantially perpendicular to the first lateral faces of the portions of the electric contact element (114).

2. Electronic power device (100) according to claim 1, in which the first electronic power component (108, 222) comprises a first semiconductor substrate (203) forming a second main face, opposite the first main face, of each of the first electronic power components (108, 222).

3. Electronic power device (100) according to one of the preceding claims, in which the first electronic power components (108, 222) together form several switching cells, each switching cell being formed by two first electronic power components (108, 222) electrically connected together by at least one of the portions of the electric contact element (114).

4. Electronic power device (100) according to one of preceding claims, further comprising at least one heat sink (218) arranged against a second main face, opposite the first main face, of the electric contact element (114).

5. Electronic power device (100) according to one of claims 1 to 4, comprising several second electronic power components (112) of lateral type arranged on another same silicon substrate, in which all the electrodes of each of the second electronic power components (112) are arranged at a first main face of each of the second electronic power components (112) and being electrically connected to the portions of the electric contact element (114) at a second main face of the electric contact element (114), and the second electronic power components (112) are arranged one above the other along a direction substantially perpendicular to the first lateral faces of the portions of the electric contact element (114), each of the second electronic power components (112) forming part of the stack and forming, with one of the first electronic power components (108, 222), a switching cell.

6. Electronic power device (100) according to one of the preceding claims, further comprising, when the first and/or second electronic power component(s) (108, 112, 222) form at least one switching cell, at least:
- a decoupling capacitor (116) connected to the switching cell such that the switching cell is arranged between the support (102) and the decoupling capacitor (116), and/or
- a control circuit (118) capable of controlling a switching of the switching cell and arranged on a rear face of the support (102) which is opposite a front face of the support (102) at which are located the metallizations (104), and/or
- heat sinks (128, 130) arranged against the second main faces of the first and second substrates (106, 110, 203, 205) opposite the first main faces.

7. Electronic power device (100) according to claim 6, in which the heat sinks (128, 130) form part of a package resting on the support (102) and in which said stack is arranged, a bottom wall (150) of the package forming an additional heat sink.

8. Static converter (200) comprising at least one electronic power device (100) according to one of the preceding claims forming at least one switching cell.

9. Method for producing an electronic power device (100), comprising at least the implementation of the following steps:
- producing, on a same silicon substrate, several first electronic power components (108, 222) of lateral type in which all the electrodes of each of the first electronic power components (108, 222) are arranged at a first main face of each of the first electronic power components (108, 222);
- making each of the first electronic power components (108, 222) integral with at least one electric contact element (114) such that a first main face of the electric contact element (114) is arranged against the first main face of each of the first electronic power components (108, 222), electrically connecting several separate portions (114.1 - 114.11) of the electric contact element (114) to the electrodes of each of the first electronic power components (108, 222), the first electronic power components (108, 222) and the electric contact element (114) together forming a stack;
- making at least one first lateral face of each of the portions (114.1 - 114.11) of the electric contact element (114), substantially perpendicular to the first main face of the electric contact element (114), integral against at least one metallization (104) of a support (102) forming at least one electric contact of each of the first electronic power components (108, 222)
and in which the first electronic power components (108, 222) are arranged one above the other along a direction substantially perpendicular to the first lateral faces of the portions of the electric contact element (114).

10. Method according to claim 9, further comprising, before making the electric contact element (114) integral with the support (102), the steps of:
- producing, on a same silicon substrate, several second electronic power components (112) of lateral type in which all the electrodes of each of the second electronic power components (112) are arranged at a first main face of each of the second electronic power components (112),
- making each the second electronic power components (112) integral with a second main face, opposite the first main face, of the electric contact element (114), such that the second main face of the electric contact element (114) is arranged against the first main face of the second electronic power component (112) and electrically connecting the electrodes of each of the second electronic power components (112) to the portions (114.1 - 114.11) of the electric contact element (114), and such that the second electronic power components (112) are arranged one above the other along a direction substantially perpendicular to the first lateral faces of the portions of the electric contact element (114), each of the second electronic power components (112) forming part of the stack and forming, with one of the first electronic power components (108, 222), a switching cell.

11. Method according one of claims 9 and 10, further comprising, when the first and/or second electronic power component(s) (108, 112, 222) form at least one switching cell:
- the assembly of at least one decoupling capacitor (116) on a lateral face of the stack, electrically connected to the switching cell such that the switching cell is arranged between the support (102) and the decoupling capacitor (116), and/or
- the assembly of at least one control circuit (118), capable of controlling a switching of the switching cell, on a rear face of the support (102) opposite a front face at which are located the metallizations (104), and/or
- the assembly of heat sinks (128, 130) against second main faces, opposite the first main faces, of the first and second substrates (106, 110, 203, 205).

12. Method according to claim 11, in which the heat sinks (128, 130) form part of a package resting on the support (102) and in which said stack is arranged, a bottom wall (150) of the package forming an additional heat sink.

13. Method for producing a static converter (200), comprising the implementation of a method for producing an electronic power device (100) according to one of claims 9 to 12 forming at least one switching cell.
